# EUROPEAN PATENT SPECIFICATION

(11) **EP 1 698 934 B1**
(45) Date of publication and mention of the grant of the patent: **04.02.2009**
(21) Application number: 06004382.5
(22) Date of filing: 03.03.2006
(51) Int. Cl.: G03F 7/031, G03F 7/033

(54) **Lithographic printing plate precursor**
Lithographischer Druckplattenvorläufer
Précurseur de plaque d'impression lithographique

(30) Priority: 03.03.2005 JP 2005059193
(43) Date of publication of application: 06.09.2006
(73) Proprietor: FUJIFILM Corporation, Minato-ku Tokyo (JP)
(72) Inventor: Inno, Toshifumi, Yoshida-cho, Haibara-gun, Shizuoka (JP)
(74) Representative: HOFFMANN EITLE

(56) References cited:
- EP-A- 1 502 735
- WO-A-20/04074930
- GB-A- 1 582 199
- US-A- 3 597 343
- US-A1- 2003 129 523

## Description

### FIELD OF THE INVENTION

The present invention relates to a negative-working lithographic printing plate precursor which is capable of being directly drawn with a laser beam.

### BACKGROUND OF THE INVENTION

In negative-working lithographic printing plate precursors, in general, image formation is carried out by a process of coating a photosensitive composition on a support, for example, an aluminum plate subjected to surface roughening treatment, exposing a desired image to polymerize or crosslink the exposed area in the photosensitive layer thereby insolubilizing it in a developing solution, and dissolving out the unexposed area with the developing solution. As the photosensitive compositions used for such a purpose, photopolymerizable compositions have hitherto been well known, a part of which is already put into practical use. Also, in recent high-sensitive photopolymers which adopt a photoinitiation system technology that is highly sensitive to visible light, the sensitivity increases to a region employable for direct plate making by a visible laser, and a so-called CTP plate becomes widespread.

In order to respond to increase in drawing speed for pursuit of higher productivity, further increase in the sensitivity is necessary. Not only that, requirement for handling ability not in a dark room but under a yellow lamp or a white lamp (treatment in a bright room) increases in view of workability. For the purpose of increase in the sensitivity, design and development of photopolymerization initiators or photopolymerization initiation systems have been made, and hexaarylbiimidazole photopolymerization initiators draw attention as highly sensitive photopolymerization initiators. Many of the hexaarylbiimidazole photopolymerization initiators do not have absorption in the visible region and a photosensitive composition containing the hexaarylbiimidazole photopolymerization initiator makes it possible to conduct the treatment in a bright room in combination with an exposure system of a ultraviolet to violet laser having a wavelength of 300 to 450 nm or an infrared laser having a wavelength of 800 to 1,200 nm.

However, the hexaarylbiimidazole photopolymerization initiator alone has insufficient sensitivity and thus, it is necessary to use a sensitizing dye or a chain transfer agent. It is known that as the chain transfer agent, a thiol compound is ordinarily used (see, for example, U.S. Patent 5,256,520). It is also proposed that as the sensitizing dye, an oxazole compound is used (see, for example, WO 04/074930). However, these techniques are still insufficient in respect to reproducibility of fine lines and printing durability.

### SUMMARY OF THE INVENTION

An object of the present invention is to provide a lithographic printing plate precursor which is capable of being directly drawn with a laser beam and which is excellent in the reproducibility of fine lines and printing durability.

As a result of various investigations, the inventor has found that the above-described object can be achieved by using a polymerization- initiation system containing a specific sensitizing dye in combination with a binder polymer having a crosslinkable group. Specifically, the present invention includes the following items.
1. A lithographic printing plate precursor comprising a support having thereon a photosensitive layer containing (A) a sensitizing dye represented by formula (I) shown below, (B) a polymerization initiator, (C) a polymerizable compound, and (D) a binder polymer having a molecular weight of 10,000 to 200,000 and having a crosslinkable group, 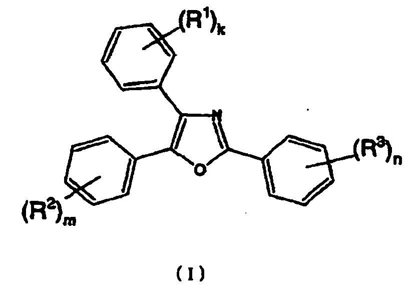 wherein R¹, R² and R³ each independently represents a halogen atom, an alkyl group which may have a substituent, an aryl group which may have a substituent, an aralkyl group which may have a substituent, an -NR⁴R⁵ group or an -OR⁶ group; R⁴, R⁵ and R⁶ each independently represents a hydrogen atom, an alkyl group which may have a substituent, an aryl group which may have a substituent or an aralkyl group which may have a substituent; and k, m and n each independently represents 0 or an integer of 1 to 5.
2. The lithographic printing plate precursor as described in item 1 above, wherein k, m and n in the sensitizing dye represented by formula (1) each independently represents 0 or 1.
3. The lithographic printing plate precursor as described in item 1 or 2 above, wherein at least one of R¹, R² and R³ in the sensitizing dye represented by formula (I) represents the -NR⁴R⁵ group.
4. The lithographic printing plate precursor as described in item 1 above, wherein (D) the binder polymer having a crosslinkable group is a (meth)acrylic copolymer having a crosslinkable group in a side chain or a polyurethane resin having a crosslinkable group in a side chain.
5. The lithographic printing plate precursor as described in any one of items 1 to 4 above, wherein the photosensitive layer further contains (E) a chain transfer agent.
6. The lithographic printing plate precursor as claimed in item 5 above, wherein (E) the chain transfer agent is a thiol compound represented by the following formula (II): 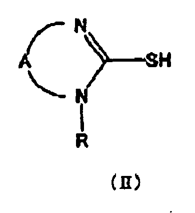 wherein R represents an alkyl group which may have a substituent or an aryl group which may have a substituent; and A represents an atomic group necessary for forming a 5-membered or 6-membered hetero ring containing a carbon atom together with the N=C-N linkage, and A may have a substituent.
7. The lithographic printing plate precursor as claimed in any one of items 1 to 6 above, wherein (B) the polymerization initiator is a hexaarylbiimidazole compound or a metallocene compound.
8. The lithographic printing plate precursor as claimed in any one of items 1 to 7 above which further comprises a protective layer on the photosensitive layer.
9. A plate-making method of a lithographic printing plate comprising imagewise exposing the lithographic printing plate precursor as claimed in any one of items 1 to 8 above with a laser beam of 350 to 600 nm, and being subjected to development processing using a developer.
10. The plate-making method of a lithographic printing plate as claimed in item 9 above, wherein the developer contains a nonionic surfactant having a polyoxyalkylene ether group.

According to the present invention, a lithographic printing plate precursor which is capable of being directly drawn with a laser beam and which is excellent in the reproducibility of fine lines and printing durability is provided.

### DETAILED DESCRIPTION OF THE INVENTION

### [Photosensitive Layer]

The photosensitive layer according to the invention contains (A) a sensitizing dye represented by formula (I), (B) a polymerization initiator, (C) a polymerizable compound, and (D) a binder polymer having a crosslinkable group. The photosensitive layer according to the invention may also contain, if desired, (E) a chain transfer agent and other components.

The constituting components of the photosensitive layer will be described in detail below.

### (A) Sensitizing Dye

The sensitizing dye used in the invention is an oxazole compound represented by the following formula (I). 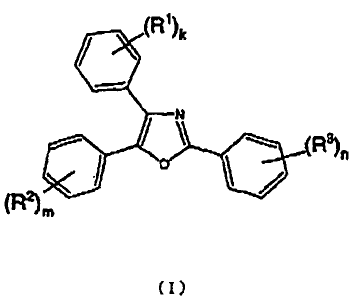 wherein R¹, R² and R³ each independently represents a halogen atom, an alkyl group which may have a substituent, an aryl group which may have a substituent, an aralkyl group which may have a substituent, an -NR⁴R⁵ group or an -OR⁶ group; R⁴ and R⁵ each independently represents a hydrogen atom, an alkyl group which may have a substituent, an aryl group which may have a substituent or an aralkyl group which may have a substituent; R⁶ represents a hydrogen atom, an alkyl group which may have a substituent, an aryl group which may have a substituent or an aralkyl group which may have a substituent; and k, m and n each represents 0 or an integer of 1 to 5.

When at least one of R¹, R² and R³ is an alkyl group which may have a substituent, examples of the substituent include -CN, -NO₂, -NR'₂, -COOR' and -OR', wherein R' represents a hydrogen atom or an alkyl group.

Preferably, R¹, R² and R³ each independently represents a halogen atom, an alkyl group having from 1 to 8 carbon atoms or an -NR⁴R⁵ group, and R⁴ and R⁵ each independently represents preferably a hydrogen atom or an alkyl group having from 1 to 6 carbon atoms. k, m and n each independently represents preferably 0 or 1.

Among them, the oxazole compounds represented by formula (I) wherein at least one of R¹, R² and R³ represents an NR⁴R⁵ group, and preferably R⁴ and R⁵ each independently represents a hydrogen atom or an alkyl group having from 1 to 6 carbon atoms, most preferably both R⁴ and R⁵ each independently represents an alkyl group having from 1 to 6 carbon atoms, are particularly preferred.

The oxazole compounds used in the invention can be synthesized according to known methods. For instance, they can be synthesized according to methods described in DE-A-1, 120,875 and EP-A-129,059 with changing starting materials.

The sensitizing dye is used in combination with one or more kinds of polymerization initiators.

The amount of the sensitizing dye added is not particularly restricted and it is preferably from 0.2 to 25% by weight, particularly preferably from 0.5 to 15% by weight, based on the total solid content of the photosensitive layer.

### (B) Polymerization Initiator

The polymerization initiator used in the invention includes, for example, a trihalomethyl compound, a carbonyl compound, an organic peroxide, an azo compound, an azido compound, a metallocene compound, a hexsarylbiimidazole compound, an organic boron compound, a disulfone compound, an oximester compound and an onium salt compound. Among them, the polymerization initiator is preferably at least one selected from the group consisting of the hexaarylbiimidazole compound, onium salt compound, trihalomethyl compound and metallocene compound In particular, the hexaarylbiimidazole compound is preferable. The polymerization initiators may be appropriately used in combination of two or more thereof.

The hexaarylbiimidaizole polymerization initiator includes, for example,
lophine dimers described in JP-B-45-37377 and JP-B-44-86516, specifically,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tedraphenylbiixnidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazote,
2,2'-bis(o-methylphenyl)-4,4',5,5'-tetraphenylbiimidazole and
2,2'-bis(o-trifluoromethylphenyl)-4,4',5,5'-tetraphenylbiimidazole.

The trihalomethyl compound preferably includes trihalomethyl-s-triazines, and
specifically s-triazine derivatives having a trihalogen-substituted methyl group
described in JP-A-58-29803, for example, 2,4,6-tris(trichloromethyl)-s-triazine,
2-methoxy-4,6-bis(trichloromethyl)-s-triazine,
2-amino-4,6-bis(trichloromethyl)-s-triazine and
2-(p-methoxystyryl)-4.6-bis(tricbloromethyl)-s-triazine.

The onium salt includes, for example, onium salts represented by the following formula (III):

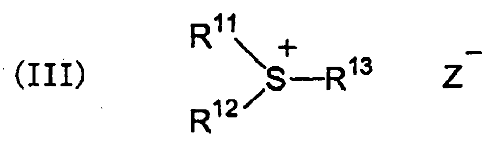

In formula (III), R¹¹, R¹² and R¹³, which may be the same or different, each represents a hydrocarbon group having 20 or less carbon atoms which may have a substituent. Preferred examples of the substituent include a halogen atom, a nitro group, an alkyl group having 12 or less carbon atoms, an alkoxy group having 12 or less carbon atoms and an aryloxy group having 12 or less carbon atoms. Z⁻ represents a counter ion selected from the group consisting of a halogen ion, a perchlorate ion, a tetrafluoroborate ion, a hexafluorophosphate ion, a carboxylate ion and a sulfonate ion, and preferably a perchlorate ion, a hexafluorophosphate ion, a carboxylate ion or an arylsulfonate ion.

The titanocene compound can be used by appropriately selecting, for example,
from known compounds as described in JP-A-59-152396 and JP-A-61-151197.
Specific examples thereof include dicyclopentadienyl-Ti-dichloride,
dicyclopentadienyl-Ti-bisphenyl,
dicyclopentadienyl-Ti-bis-2,3,4,5,6-pentafluorophen-1-yl,
dicyclopentadienyl-Ti-bis-2,3,5,6-tetrafluorophen-1-yl,
dicyclopentadienyl-Ti-bis-2,4,6-trifluorophen-1-yl,
dicyclopentadienyl-Ti-bis-2,6-difluorophen-1-yl,
dicyclopentadienyl-Ti-bis-2,4-difluorophen-1-yl,
dimethylcyclopentadienyl- Ti-bis-2,3,4,5, 6-pentafluorophen-1-yl,
dimethylcyclopentadienyl-Ti-bis-2,3,5,6-tetrafluorophen-1-yl,
dimethylcyclopentadienyl-Ti-bis-2,4-difluorophen-1-yl and
bis(cyclopentadienyl)-bis-(2,6-difluoro-3-(pyr-1-lyl)phenyl) titanium.

The carbonyl compound described above includes, for example, a
benzophenone derivative, e.g., benzophenone, Michler's ketone, 2-methylbenzophenone,
3-methylbenzophenone, 4-methylbenzophenone, 2-chlorobenzophenone,
4-bromobenzophenone or 2-carboxybenzophenone, an acetophenone derivative, e.g.,
2,2-dimethoxy-2-phenylacetophenone, 2,2-diethoxyacetophenone,
1-hydroxycyclohexylphenylketone, α-hydroxy-2-methylphenylpropane,
1-hydroxy-1-methylethyl-(p-isopropylphenyl)ketone,
1-hydroxy-1-(p-dodecylphenyl)ketone,
2-methyl-(4'-(methylthio)phenyl)-2-morpholino-1-propane or
1,1,1-trichloromethyl-(p-butylphenyl)ketone, a thioxantone derivative, e.g., thioxantone,
2-ethylthioxantone, 2-isopropylthioxantone, 2-chlorothioxantone,
2,4-dimetylthioxantone, 2,4-dietyIthioxantone or 2,4-diisapropylthioxantone, and a
benzoic acid ester derivative, e.g., ethyl p-dimethylaminobenzoate or ethyl
p-diethylaminobenzoate.

The oximester compound described above includes, for example, compounds described in J. C. S. Perkin II, 1653-1660 (1979), J. C. S. Perkin II, 156-162 (1979), Journal of Photopolymer Science and Technology, 202-232 (1995), JP-A-2000-66385 (the term "JP-A" as used herein means an "unexamined published Japanese patent application") and JP-A-2000-80068.

The polymerization initiators can be preferably used individually or in combination of two or more thereof in the invention. The amount of the polymerization initiator used in the photosensitive layer according to the invention is preferably from 0.01 to 20% by weight, more preferably from 0.1 to 15% by weight, still more preferably from 1.0 to 10% by weight, based on the total solid content of the photosensitive layer.

### (C) Polymerizable Compound

The polymerizable compound used in the photosensitive layer according to the invention is an addition-polymerizable compound having at least one ethylenically unsaturated double bond and it is selected from compounds having at least one, preferably two or more, terminal ethylenically unsaturated double bonds. Such compounds are broadly known in the field of art and they can be used in the invention without any particular limitation. The compound has a chemical form, for example, a monomer, a prepolymer, specifically, a dimer, a trimer or an oligomer, or a copolymer thereof, or a mixture thereof Examples of the monomer and copolymer thereof include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid is also preferably used. Furthermore, an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tebraacrylate, sorbitol pentaacrylate, sorbitol hexaacrylate, tri(acryloyloxyethyl) isocyanurate, isocyanuric acid ethylene oxide (EO) modified triacrylate or polyester acrylate oligomer,
methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerytbritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane;
itaconic acid esters, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate; crotonic acid esters, for example, ethylene glycol dicrotonate, tetramethylene glycol dicrotonate, pentaerythritol dicrotonate or sorbitol tetradicrotonate, isocrotonic acid esters, for example, ethylene glycol diisocrotonate, pentaorythritol diisocrotonate or sorbitol tetraisocrotonate; and maleic acid esters, for example, ethylene glycol dimaleate, triethylene glycol dimaleate, pentaerythritol dimaleate and sorbitol tetramaleate.

Other examples of the ester, which can be preferably used, include aliphatic alcohol esters described in JP-B-51-47334 (the term "JP-B" as used herein means an "examined Japanese patent publication") and JP-A-57-196231, esters having an aromatic skeleton described in JP-A-59-5240, JP-A,-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriananne trisacrylamide, xylylene bisacrylamide and xylylene bismothacrylamide. Other preferred examples of the amide monomer include amides having a cyclohexylene structure described in JP-B-54-21726.

Urethane type addition polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂-C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Furthermore, a photopolymerizable composition having remarkably excellent photosensitive speed can be obtained by using an addition polymerizable compound having an amino structure or a suLfide structure in its molecule, described in JP-A-63-277653, JP-A-63-260909 and JP-A.-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the polymerizable compound, for example, selection of the structure, individual or combination use, or an amount added, can be appropriately arranged depending on the characteristic design of the final lithographic printing plate precursor. For instance, the compound is selected from the following standpoints.

In view of the sensitivity, a structure having a large content of unsaturated groups per molecule is preferred and in many cases, a bifunctional or more functional compound is preferred. In order to increase the strength of image area, that is, hardened layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to a support or a protective layer described hereinafter.

The polymerizable compound is preferably used in an amount from 5 to 80% by weight, more preferably from 25 to 75% by weight, based on the total solid content of the photosensitive layer. The polymerizable compounds may be used individually or in combination of two or more thereof In the method of using the polymerizable compound, the structure, blend and amount added can be appropriately selected by taking account of the degree of polymerization inhibition due to oxygen, resolution, fogging property, change in refractive index, surface adhesion and the like. Further, depending on the case, a layer construction, for example, an undercoat layer or an overcoat layer, and a coating method, may also be considered.

### (D) Binder Polymer

In the invention, a binder polymer is used as the essential component in order to improve the film property and developing property of the photosensitive layer. Further, the binder polymer used in the invention is characterized by having a crosslinkable property in order to improve the film strength of the image area. In order to impart the crosslinkable property to the binder polymer, a crosslinkable functional group, for example, an ethylenically unsaturated bond is introduced into a main chain or side chain of the polymer. The crosslinkable functional group may be introduced by copolymerization or a polymer reaction.

### [Polymer Binder Having Crosslinkable Group in Side Chain]

In the photosensitive layer according to the invention, a polymer binder having a crosslinkable group in a side chain is used. The crosslinkable group means a group capable of crosslinking the polymer binder in the process of a radical polymerization reaction which is caused in the photosensitive layer, when the photosensitive lithographic printing plate is exposed to light. The crosslinkable group is not particularly restricted as long as it has such a function and includes, for example, an ethylenically unsaturated bonding group, an amino group or an epoxy group as a functional group capable of conducting an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bonding group is preferable, and functional groups represented by formulae (1) to (3) shown below are particularly preferable.

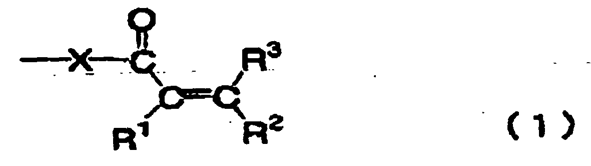

In formula (1), R¹ to R³ each independently represents a hydrogen atom or a monovalent organic group. R¹ preferably includes, for example, a hydrogen atom or an alkyl group which may have a substituent. Among them, a hydrogen atom or a methyl group is preferable because of high radical reactivity. R² and R³ each independently preferably includes, for example, a hydrogen atom, a halogen atom, an amino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

X represents an oxygen atom, a sulfur atom or -N(R¹²)-, and R¹² represents a hydrogen atom or a monovalent organic group. The organic group represented by R¹² includes, for example, an alkyl group which may have a substituent. Among them, a hydrogen atom, a methyl group, an ethyl group or an isopropyl group is preferable because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxy group, an alkoxycarbonyl group, a sulfo group, a nitro group, a cyano group, an amido group, an alkylsulfonyl group and an arylsulfonyl group.

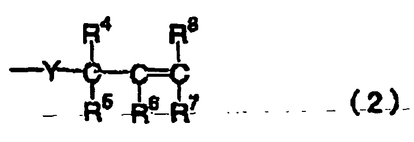

In formula (2), R⁴ to R⁸ each independently represents a hydrogen atom or a monovalent organic group. R⁴ to R⁸ each independently preferably includes, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable.

Examples of the substituent introduced include those described in Formula (1). Y represents an oxygen atom, a sulfur atom or -N(R¹²)-, and R¹² has the same meaning as R¹² defined in Formula (1). Preferred examples for R¹² are also same as those described in Formula (1).

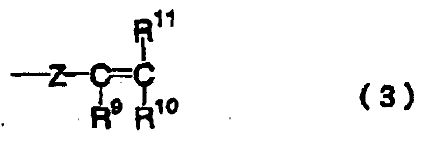

In formula (3), R⁹ represents a hydrogen atom or a monovalent organic group, and preferably represents a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

Examples of the substituent introduced include those described in Formula (1). Z represents an oxygen atom, a sulfur atom, N(R¹³)- or a phenylene group which may have a substituent. R¹³ preferably includes an alkyl group which may have a substituent. Among them, a methyl group, an ethyl group or an isopropyl group is preferable because of high radical reactivity.

The polymer binder having a crosslinkable group in a side chain according to the invention not only functions as a film-forming agent but also is preferably an organic polymer which is soluble or swellable in alkali water since it is needed to be dissolved in a developer, preferably an alkali developer. Therefore, it is preferred that the polymer binder according to the invention has an alkali-soluble group, for example, a carboxy group, in the side chain in addition to the crosslinkable group. In the case where the polymer binder having a crosslinkable group in a side chain is a water-soluble organic polymer, it is possible to conduct water development.

Examples of the polymer binder according to the invention include (meth)acrylic acid copolymers, itaconic acid copolymers, crotonic acid copolymers, maleic acid copolymers and partially esterified maleic acid copolymers each having a crosslinkable group, for example, an allyl group or a (meth)acryloyl group in the side chain thereof as described in JP-A-59-53836 and JP-A-59-71048.

Also, polyurethanes, acid cellulose derivatives and adducts between an addition polymer having a hydroxy group and a cyclic acid anhydride, each having the crosslinkable group and carboxy group in the side chain are useful as the polymer binder according to the invention.

Of the polymers, the (meth)acrylic acid copolymers and polyurethanes are more preferable. In particular, the polyurethane resins are preferable from the standpoint that development damage in the exposed area can be prevented without accompanying with decrease in developing property in the unexposed area so that both good stain resistance and high printing durability can be achieved, even when an acid value of the photosensitive layer is low.

The polyurethane resin having a crosslinkable group in the side chain thereof is described in more detail below.

The polyurethane resin having a crosslinkable group in the side chain thereof particularly preferably used in the invention can be obtained by a polyaddition reaction of (i) a diisocyanate compound, (ii)a diol compound having a carboxy group, (iii) a diisocyanate compound having a crosslinkable group, and if desired, (iv) a diol compound containing no carboxy group.

The diisocyanate compound and diol compound which are starting materials of the polyurethane resin will be described in more detail below.

### (i) Diisocyanate compound

Examples of the diisocyanate compound include diisocyanate compounds represented by the following formula (4):

OCN-L-NCO (4)

In formula (4), L represents a single bond or a divalent aliphatic or aromatic hydrocarbon group which may have a subsdtuent. If desired, L may contain other functional group which does not react with the isocyanate group, for example, a carbonyl group, an ester group, a urethane group, an amido group or a ureido group. More specifically, L represents a single bond or a divalent aliphatic or aromatic hydrocarbon group which may have a substituent (preferably, for example, an alkyl group, an aralkyl group, an aryl group, an alkoxy group or a halogeno group); preferably an alkylene group having from 1 to 20 carbon atoms or an arylene group having from 6 to 15 carbon atoms; and more preferably an alkylene group having from 1 to 8 carbon atoms. Also, if desired, L may contain other functional group which does not react with the isocyanate group, for example, a carbonyl group, an ester group, a urethane group, an amido group, a ureido group or an ether group.

Specific examples of the diisocyanate compound represented by formula (4) include the following compounds. Specifically, an aromatic diisocyanate compound, for example, 2,4-tolylene diisocyanate, dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthalene diisocyanate or 3,3'-dimethylbiphenyl-4,4'-diisocyanate, an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4(or 2,6)-diisocyanate or 1,3-(isocyanatomethyl)cyclohexane; and a diisocyanate compound obtained by a reaction of diol with diisocyanate, for example, an adduct of 1 mole of 1,3-butylene glycol with 2 moles oftolylene diisocyanate are exemplified.

The diisocyanate compounds may be used individually or in combination of two or more thereof In view of the balance between printing durability and stain resistance, it is preferred to use two or more of the diisocyanate compounds in combination, and it is particularly preferred to use at least one of the aromatic diisocyanate compounds (L represents an aromatic group) and at least one of the aliphatic diisocyanate compounds (L represents an aliphatic group).

With respect to an amount of the diisocyanate compound used, a molar ration of the diisocyanate compound to the diol compound is preferably from 0.8 to 1.2, and more preferably from 0.9 to 1.1. In the case where an isocyanate group remains at a polymer terminal because of using an excess amount of the diisocyanate compound to the diol compound, it is preferred to treat the compound after the urethanization reaction with an alcohol or an amine to finally synthesize a compound having no residual isocyanate group at the terminal.

### (ii) Diol Compound Having At Least One Carboxy Group

The diol compound having at least one carboxy group includes diol compounds represented by formulae (5), (6) and (7) shown below and/or a compound obtained by ring opening of a tetracarboxylic acid dianhydride with a diol compound. The diol compound used for the purpose of ring opening of the tetracarboxylic acid dianhydride can be used.

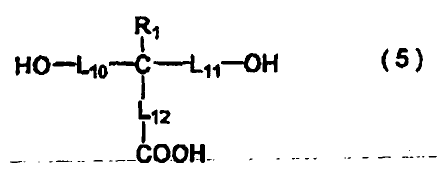

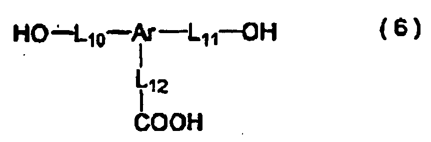

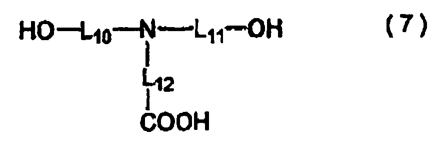

In the formulae, R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from 1, to 10 carbon atoms or an aralkyl group having from 7 to 15 carbon atoms)); and preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogeno group); preferably an alkylene group having from 1 to 20 carbon atoms or an arylene group having from 6 to 15 carbon atoms; and more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁₁, L₁₀, L₁₁ and L₁₂ may be taken together to form a ring. Ar represents a trivalent aromatic hydrocarbon group which may have substituent, and preferably an aromatic group having from 6 to 15 carbon atoms.

Specific examples of the diol compound having a carboxy group represented by formula (5), (6) or (7) include the following compounds.

Specifically, 3,5-dihydroxybenezoic Specifically, 3,5-dihydroxybenzoic acid, 2,2-bis(hydroxymethyl)propionic acid, 2,2-bis(2-hydroxyethyl) propionic acid, 2,2-bis(3-hydroxypropyl)propionic acid, bis(hydroxymethyl) acetic acid, bis(4-hydroxyphenyl)acefic acid, 2,2-bis(hydroxymethyl)butyric acid, 4,4-bis(4-hydroxyphenyl)pentanoic acid, tartaric acid, N,N-dihydroxyethylglycine and N,N-bis(2-hydroxyethyl)-3-carboxypropionaniide are exemplified.

Preferable examples of the tetracarboxylic acid dihydrate, which is used in the preparation of the diol compound having at least one carboxy group, include compounds represented by formulae (8), (9) and (10) shown below.

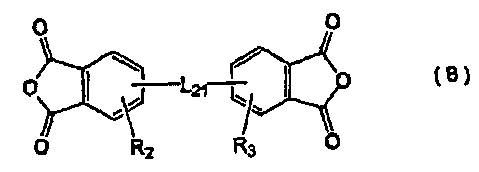

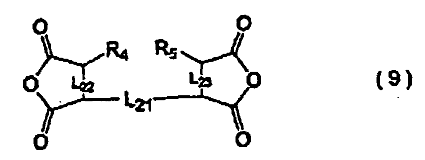

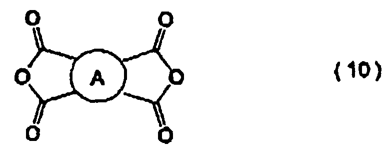

In the formulae, L₂₁ represents a single bond, a divalent aliphatic or aromatic hydrocarbon group which may have a substituent (preferably, for example, an alkyl group, an aralkyl group, an aryl group, an alkoxy group, a halogeno group, an ester group or an amido group), -CO-, -SO-, -SO₂-, -O- or -s-; and preferably a single bond, a divalent aliphatic hydrocarbon group having from 1 to 15 carbon atoms, -CO-, -SO₂-, -O- or -s-. R₂ and R₃, which may be the same or different, each represems a hydrogen atom, an alkyl group, an aralkyl group, an aryl group, an alkoxy group or a halogeno group; and preferably a hydrogen atom, an alkyl group having from 1 to 8 carbon atoms, an aryl group having from 6 to 15 carbon atoms, an alkoxy group having from 1 to 8 carbon atoms or a halogeno group. Alternatively, two of L₂₁, R₂ and R₃ may be combined with each other to form a ring. R₄ and R₅, which may be the same or different, each represents a hydrogen atom, an alkyl group, an aralkyl group, an aryl group or a halogeno group; and preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group; and preferably a single bond, a double bond or a methylene group. A represents a monocyclic or polycyclic aromatic ring; and preferably an aromatic ring having from 6 to 18 carbon atoms.

Specific examples of the compound represented by formula (8), (9) or (10) include the following compounds.

Specifically, an aromatic tetracarboxylic acid dihydride, for example,
pyromellitic acid dihydride, 3,3',4,4'-benzophenonetetracarboxylic acid dihydride,
3,3',4,4'-diphenyltetracarboxylic acid dihydride, 2,3,6,7-naphthalenetetracarboxylic
acid dihydride, 1,4,5.8-naphthalenetetracarboxylic acid dihydride,
4,4'.-sulfonyldiphthalic acid dihydride, 2,2-bis(3,4-dicarboxyphenyl)propane dihydride, bis(3,4-dicarboxyphenyl)ether dihydride,
4,4'-[3,3'(alkylphosphoryldiphenylene)-bis(iminocarbonyl)] diphthalic acid dihydride,
adduct of hydroquinonediacetate and trimellitic acid anhydride or adduct of diacetyldiamine and trimellitic acid anhydride; an alicyclic tetracarboxylic acid dihydride, for example,
5-(2,5-dioxotetrahydrofuryl)-3-methyl-3-cyclohexene-1,2-dicarboxylic acid dihydride (Epicron B-4400, produced by Dainippon Ink and Chemicals, Inc.),
1,2,3,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, (ii) the diol compound having at least one carboxy group can be synthesized. It is also possible that a reaction between the diol compound and (i) the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:
a) Method wherein an alcohol-terminated compound obtained by ring-opening of the tetracarboxylic acid dianhydride with a diol compound is reacted with the diisocyanate compound; and
b) Method wherein an alcohol-terminated urethane compound obtained by reacting the diisocyanate compound under excess of the diol compound is reacted with the tetracarboxylic acid dianhydride.

Of the diol compounds having at least one carboxylic group, the compounds represented by formula (5) are more preferable because of high solvent solubility and ease of synthesis. The diol compound having at least one carboxylic group is introduced into the polyurethane resin binder in an amount so that the polyurethane resin binder contains ordinarily from 0.2 to 4.0 meq/g, preferably from 0.3 to 3.0 meq/g, more preferably from 0.4 to 2.0 meq/g, particularly preferably from 0.5 to 1.5 meq/g, and most preferably from 0.6 to 1.2 meq/g, of the carboxy group. Therefore, although the content of the structure derived from the diol compounds having at least one carboxylic group in the polyurethane resin binder can be appropriately determined after considering a number of the carboxy group in the diol compound, other diol compound used in combination, an acid value or molecular weight of the resulting polyurethane resin binder, a composition or pH of developer and the like, it is, for example, ordinarily from 5 to 45% by mole, preferably from 10 to 40% by mole, and more prefarably from 15 to 35% by mole.

### (iii) Diisocyanate Compound Having Crosslinkable Group

The diisocyanate compound having a crosslinkable group includes, for example, a reaction product obtained by an addition reaction of a triisocyanate compound with one equivalent of a monofunctional alcohol or monofunctional amine compound having a crosslinkable group.

Examples of the triisocyanate compound are set forth below, but the invention should not be construed as being limited thereto.

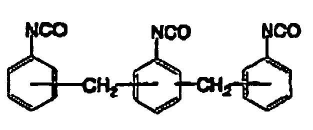

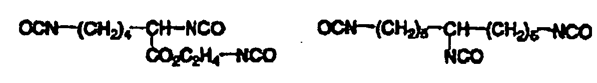

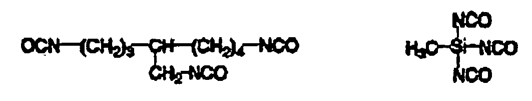

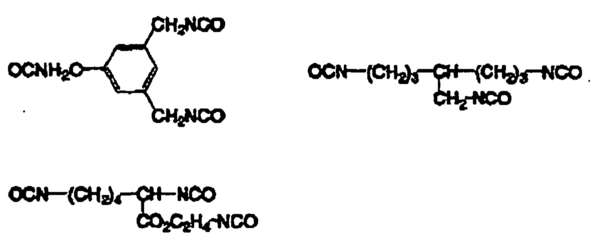

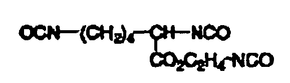

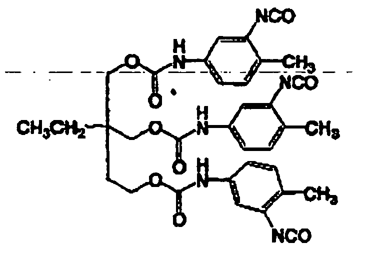

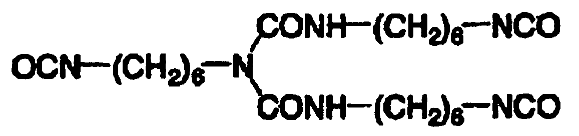

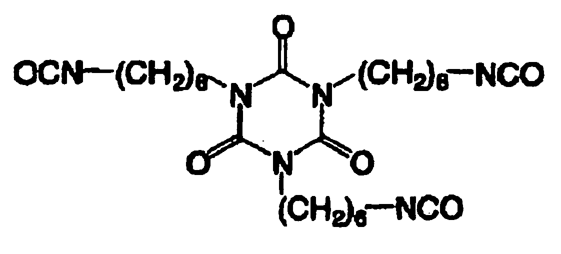

Examples of the monofunctional alcohol or monofunctional amine compound having a crosslinkable group are set forth below, but the invention should not be construed as being limited thereto.

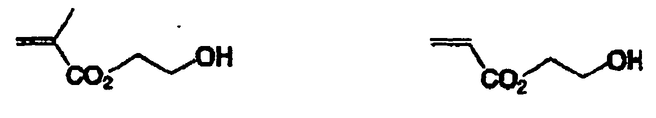

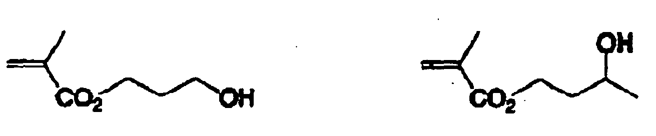

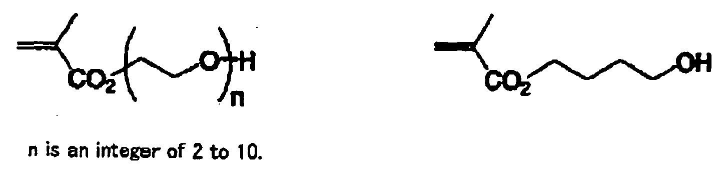

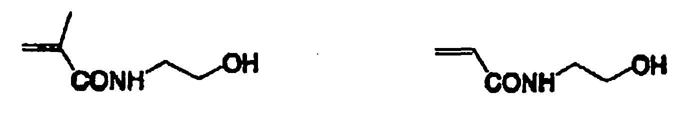

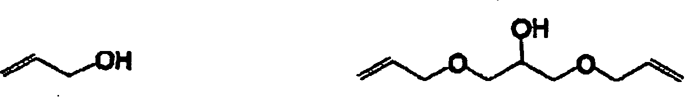

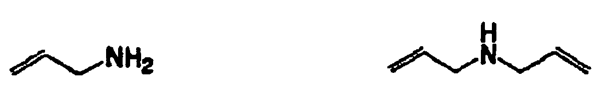

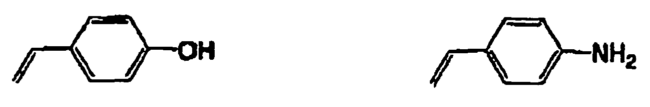

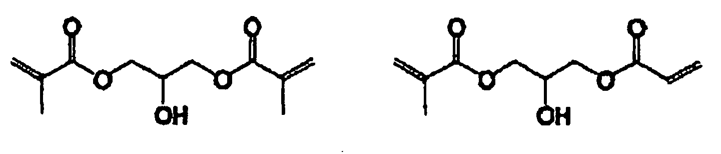

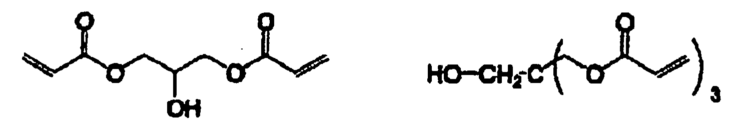

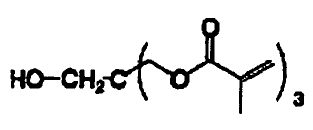

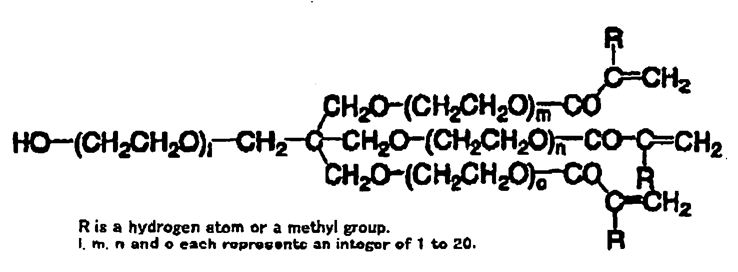

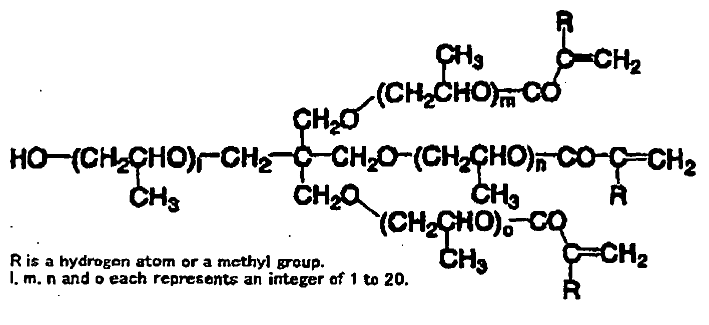

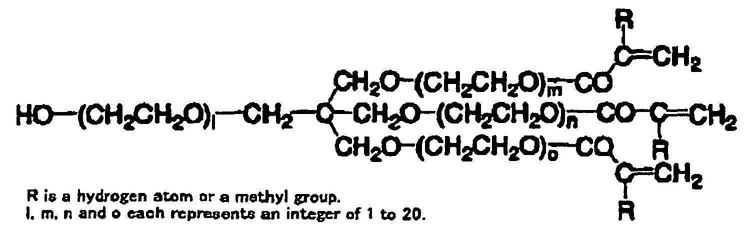

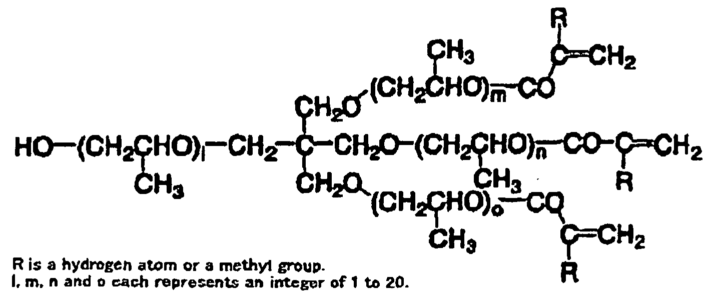

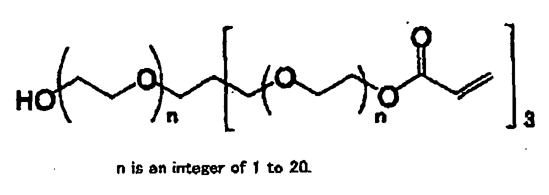

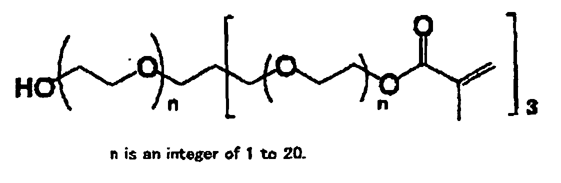

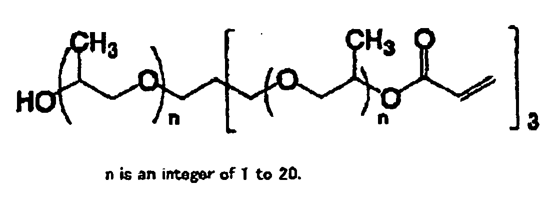

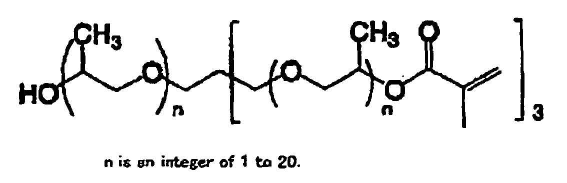

In order to introduce a crosslinkable group into the side chain of the polyurethane resin, a method of using as a raw material for the production of polyurethane resin, the diisocyanate compound having the crosslinkable group in the side chain is preferable. Specific examples of the diisocyanate compound having a crosslinkable group in the side chain obtained by an addition reaction of a triisocyanate compound with one equivalent of a monofunctional alcohol or monofunctional amine e compound having the crosslinkable group are set forth below, but the invention should not be construed as being limited thereto.

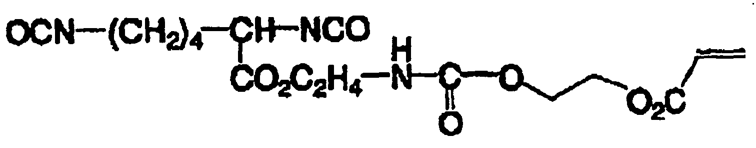

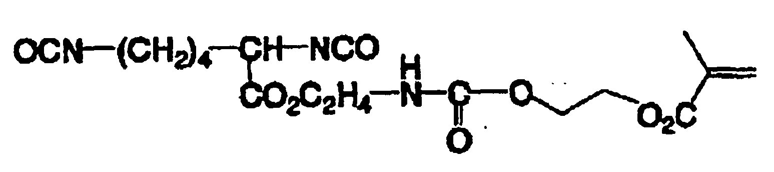

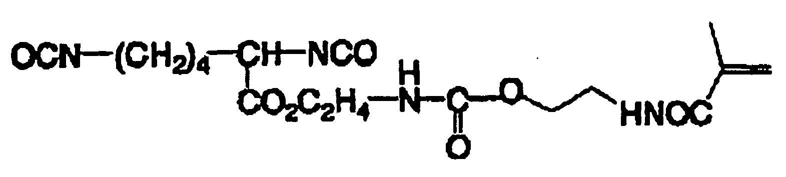

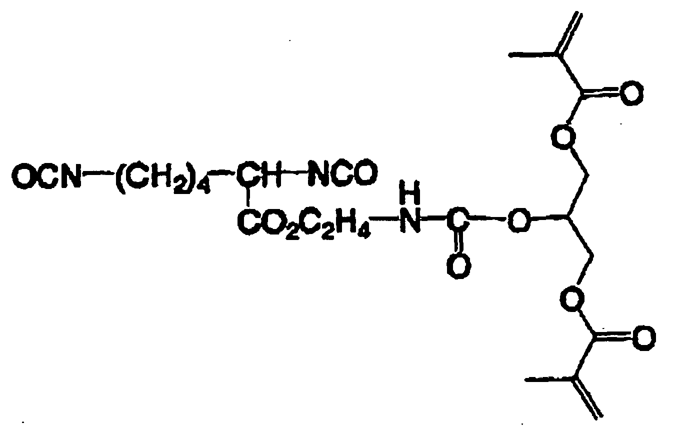

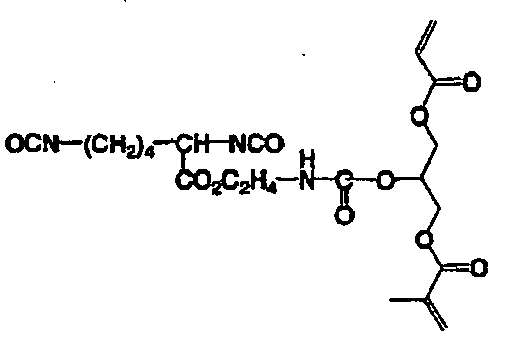

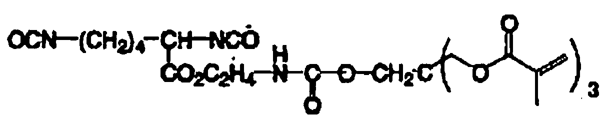

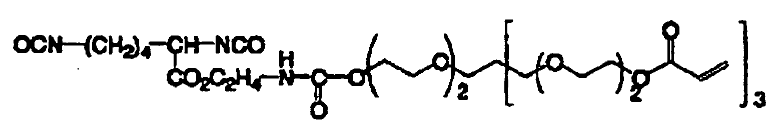

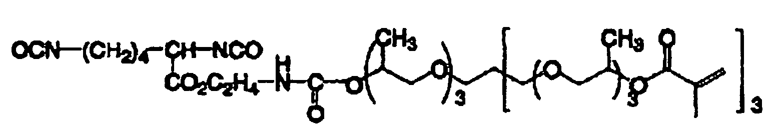

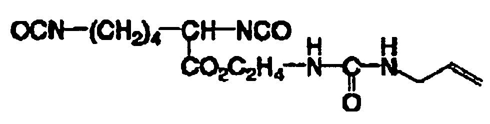

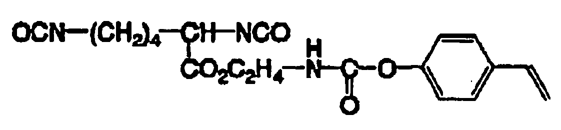

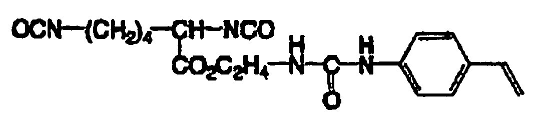

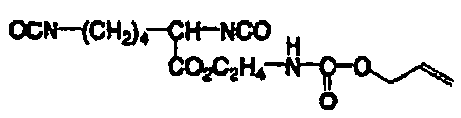

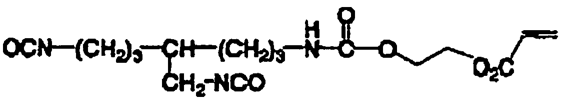

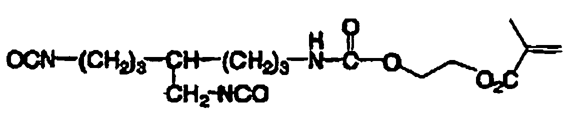

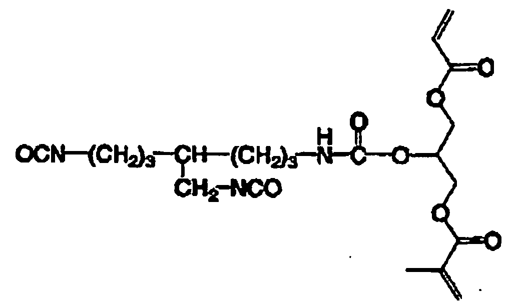

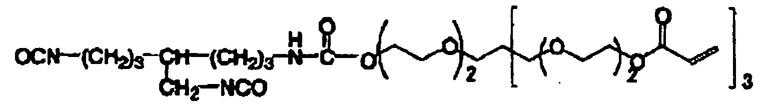

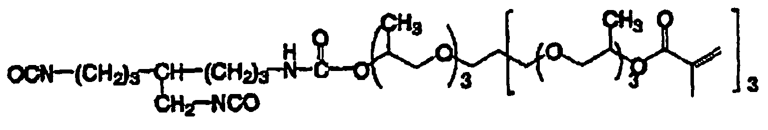

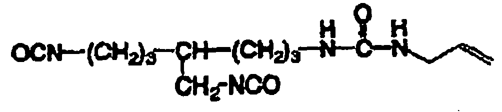

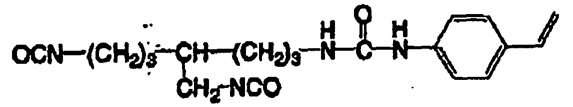

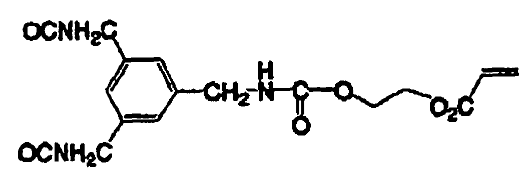

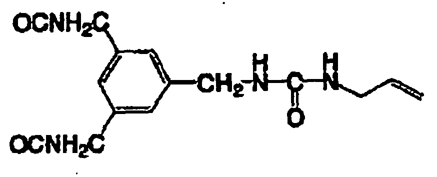

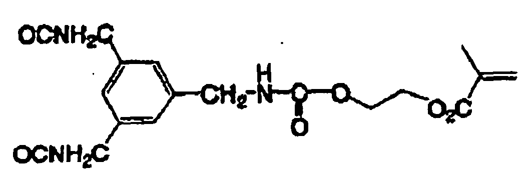

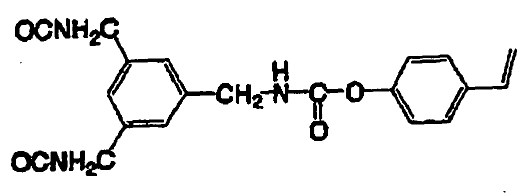

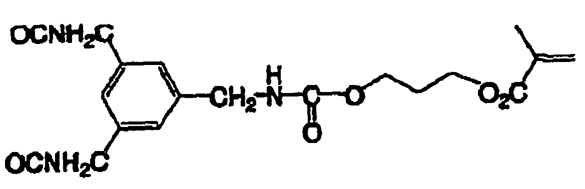

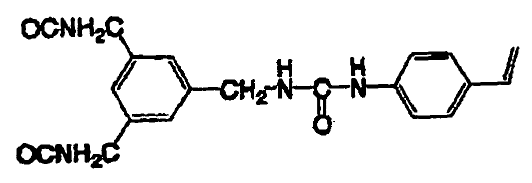

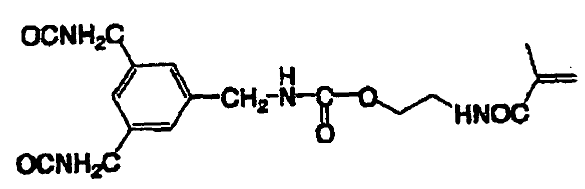

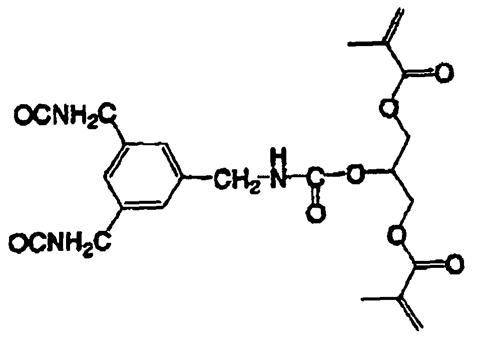

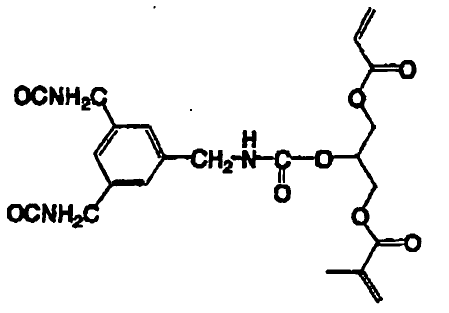

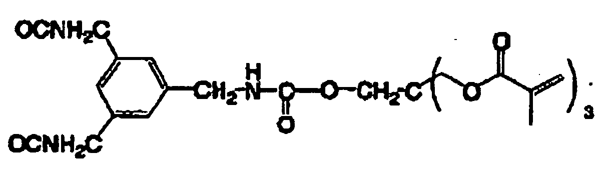

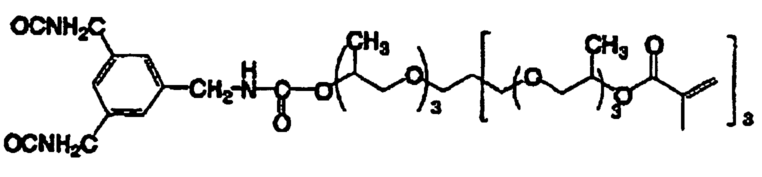

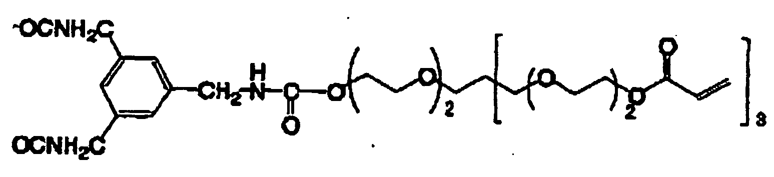

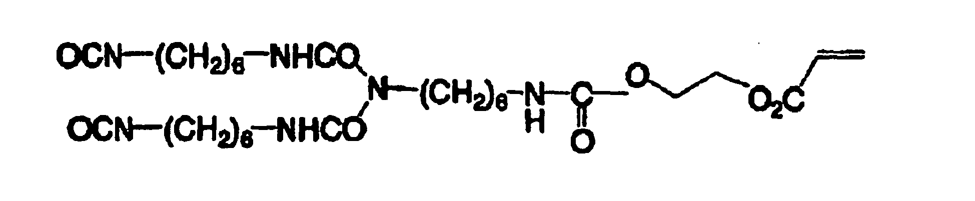

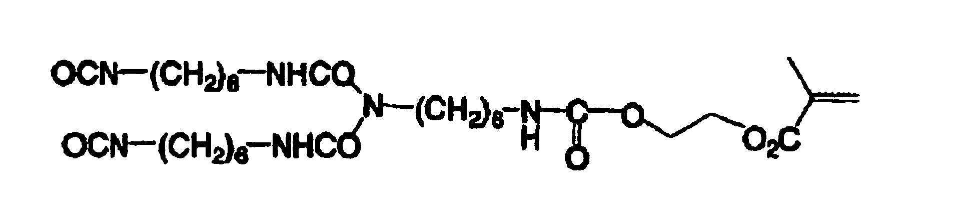

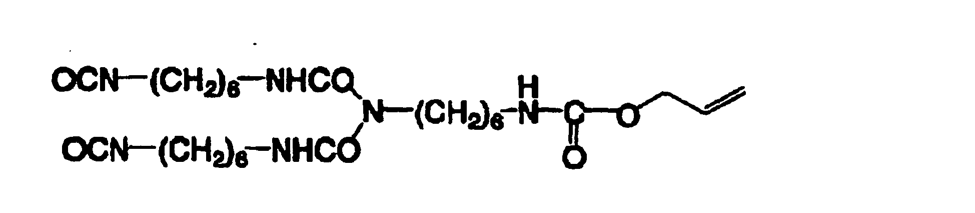

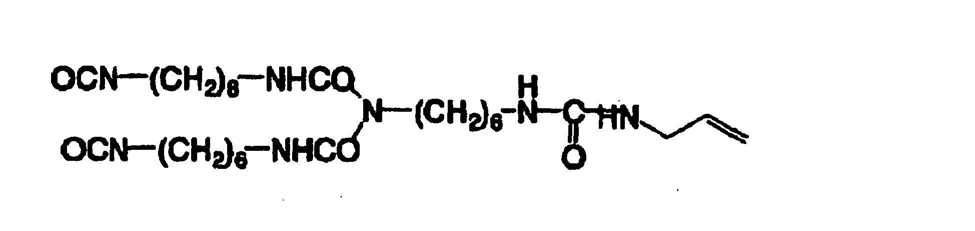

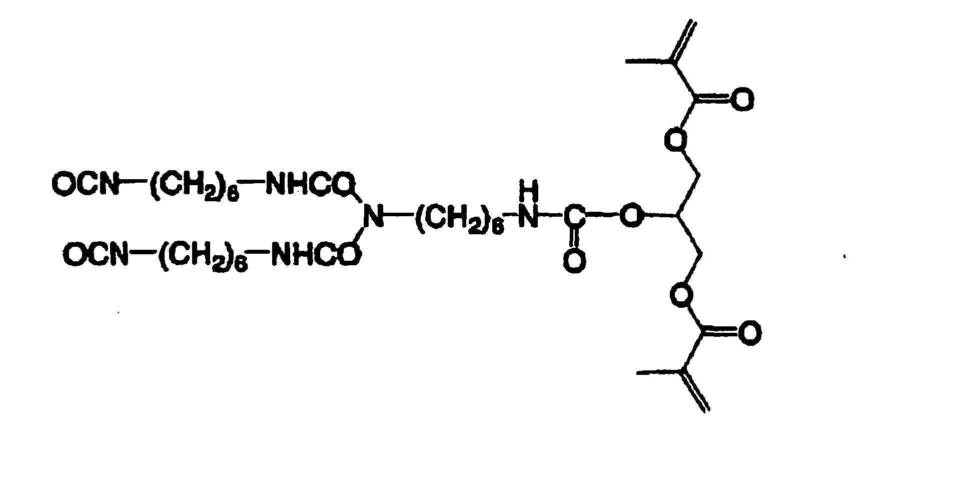

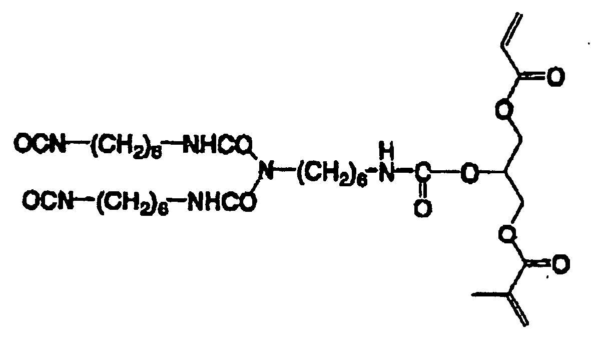

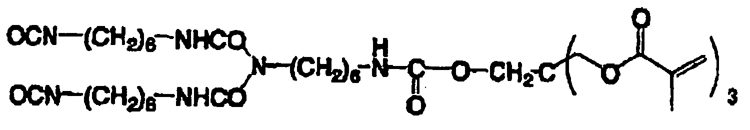

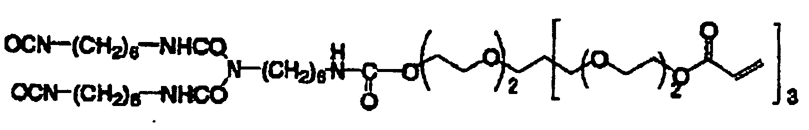

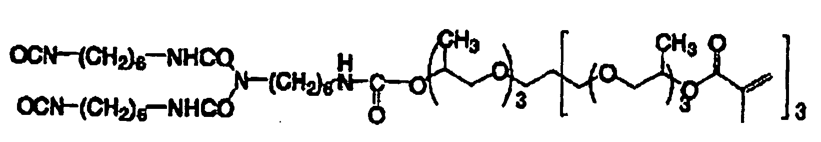

### (iv) Other Diol Compound

A method of using a diol compound having a crosslinkable group in the side chain as a raw material for the production of polyurethane resin is preferable as well as the method described above for the purpose of introducing the crosslinkable group into the side chain of the polyurethane resin. Such a diol compound may be a commercially avairable compound, for example, trimethylolpropane monoallyl ether or a compound easily produced by a reaction of a halogenated diol compound, a triol compound or an aminodiol compound with a carboxylic acid, acid chloride, isocyanate, alcohol, amine, thiol or halogenated alkyl compound having a crosslinkable group. Specific examples of the diol compound having a crosslinkable group are set forth below, but the invention should not be construed as being limited thereto.

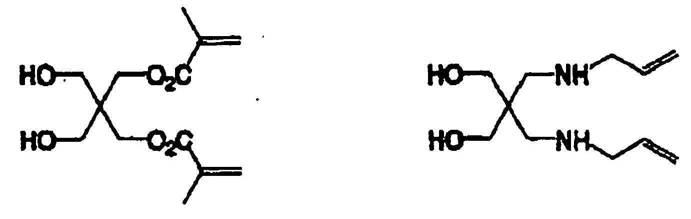

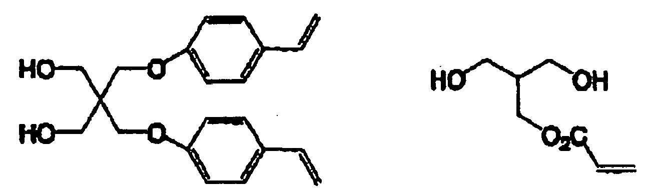

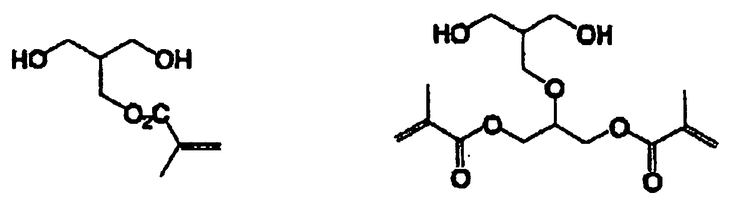

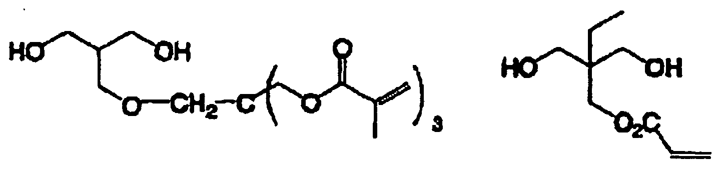

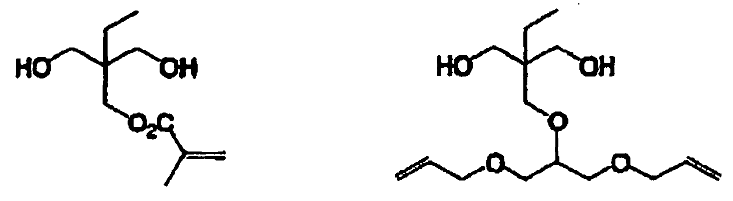

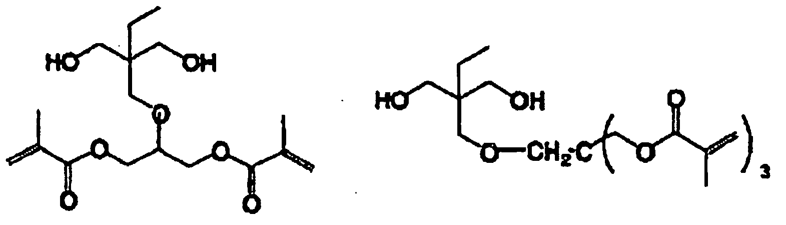

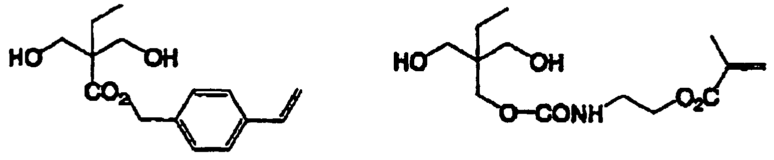

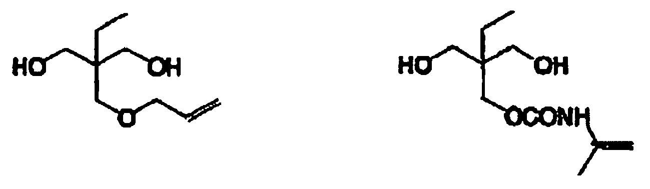

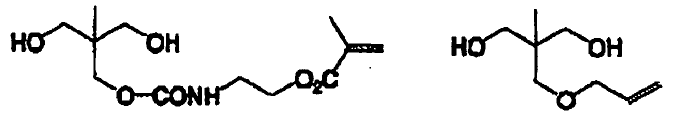

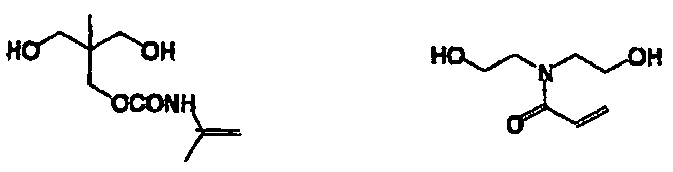

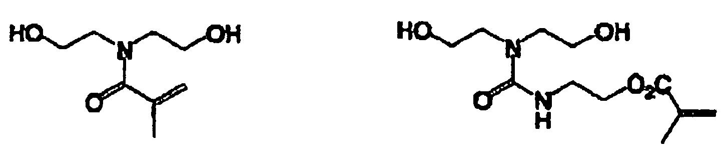

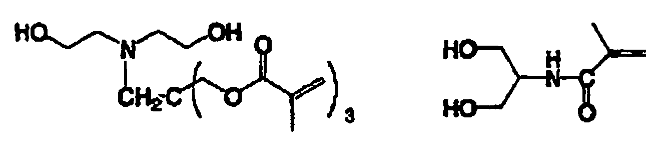

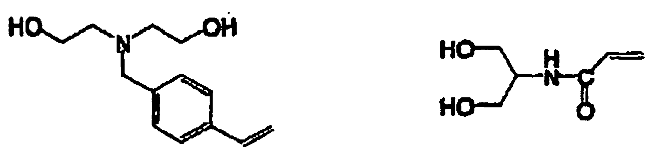

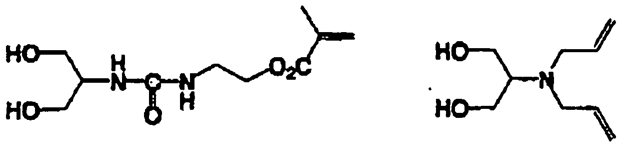

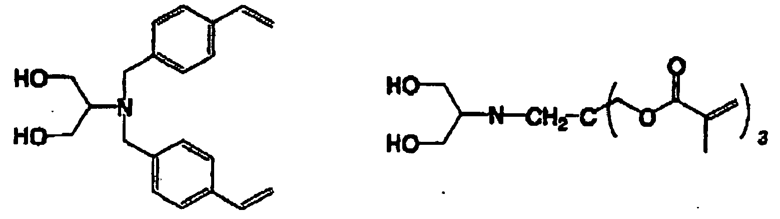

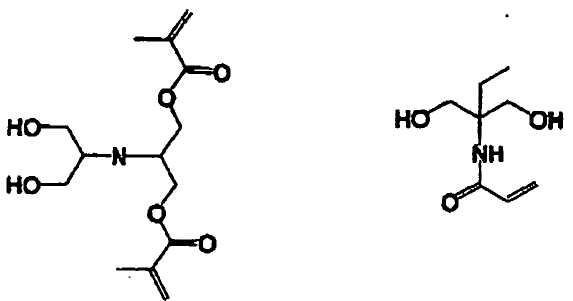

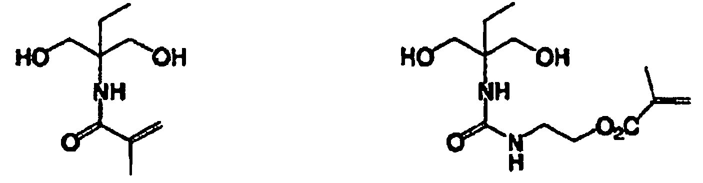

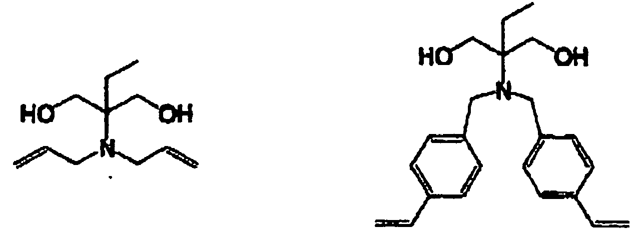

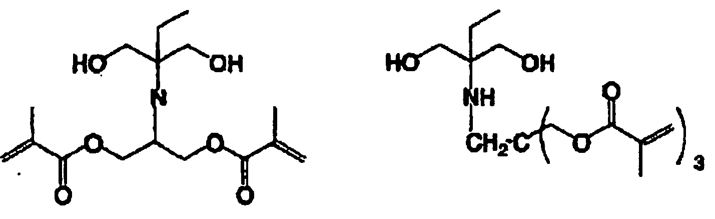

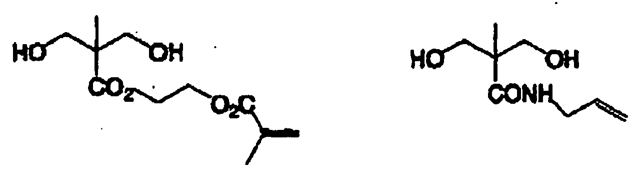

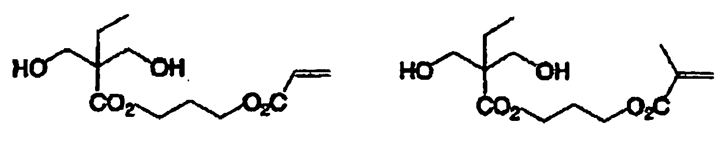

Another examples of the other diol compound include ethylene glycol compounds represented by the following formula (A'):

HO-(CH₂CH₂O)ₙ-H (A')

In the formula, n represents an integer of 1 or more.

Also, random copolymers and block copolymers between ethylene oxide and propylene oxide having hydroxy groups at the terminals are exemplified.

Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100) and an ethylene oxide adduct of hydrogenated bisphenol F (addition number of the ethylene oxide is from 18 to 100) are also used. More specifically, the ethylene glycol compounds represented by formula (A') are preferable in view of the stain resistance. The ethylene glycol compounds represented by formula (A') wherein n is form 2 to 50 are more preferable, those wherein n is form 3 to 30 are still more preferable, and those wherein n is form 4 to 10 are particularly preferable.

Specific examples thereof include 1,2-propylene glycol, di-1,2-propylene glycol, tri-1,2-propylene glycol, tetra-1,2-pmpylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3-pentanediol, 1,4-bi&-p-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), an ethylene oxide adduct of hydrogenated bisphenol F (addition number of the ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4 tolylenedicarbamate,
2,4-tolylene-bis(2-hydroxyethylcarbamide),
bis(2-hydroxyerhyl)-m-xylylenedicarbamate and bis(2-hydroxyethyl)isophthalate.

Further, polyether diol compounds of compounds represented by the following formulae (a), (b), (c), (d) and (e) are preferably used.

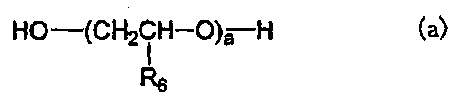

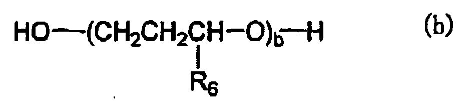

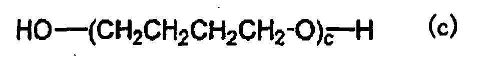

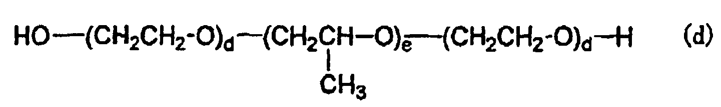

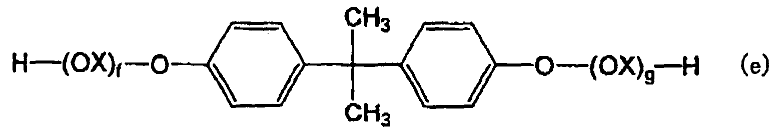

In the formulae, R₆ represents a hydrogen atom or a methyl group, provided that R₆ in formula (a) represents a methyl group. X represents a group shown below.

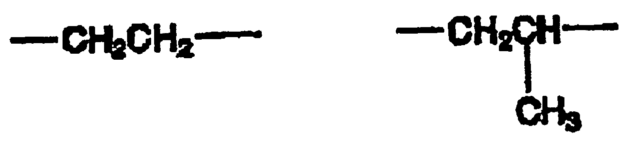

a, b, c, d, e, f and g each represents an integer of 2 or more, and preferably an integer of 2 to 100.

Polyester diol compounds represented by formulae (11) and (12) shown below are also enumerated as specific examples.

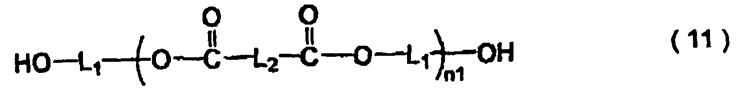

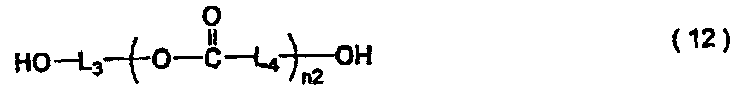

In the formulae, L₁, L₂ and L₃, which may be the same or different, each represents a divalent aliphatic or aromatic hydrocarbon group, and L₄ represents a divalent aliphatic hydrocarbon group. Preferably, L₁, L₂ and L₃ each represents an alkylene group, an alkenylene group, an alkynylene group or an arylene group, and L₄ represents an alkylene group. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom n1 and n2 each represents an integer of 2 or more, and preferably an integer of 2 to 100.

Polycarbonate diol compounds represented by formula (13) shown below are also enumerated as specific examples.

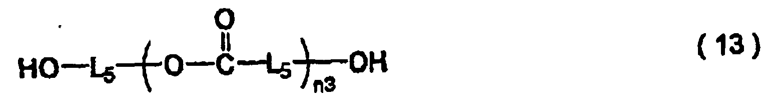

In the formula, L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n3 represents an integer of 2 or more, and preferably an integer of 2 to 100.

Specific examples of the diol compound represented by formula (11), (12) or (13) include those shown below. In the specific examples, n represents an integer of 2 or more.

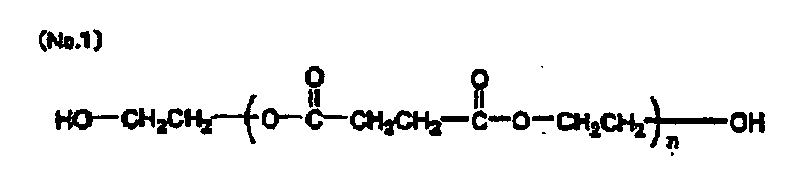

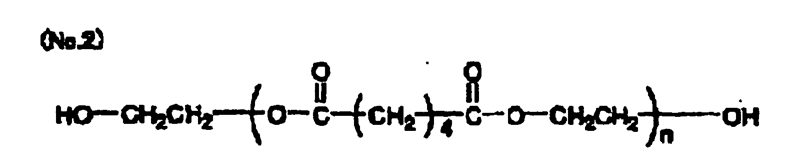

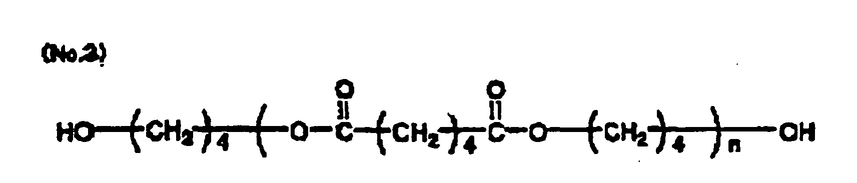

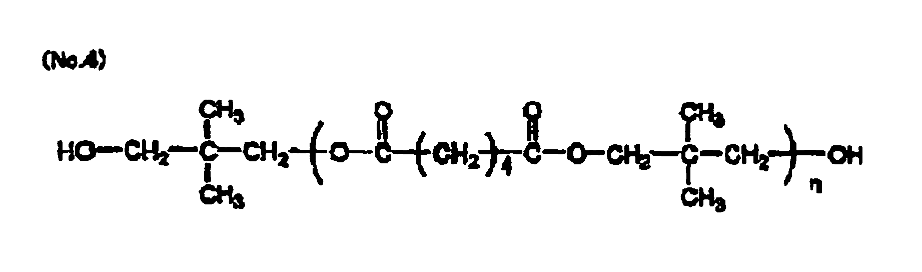

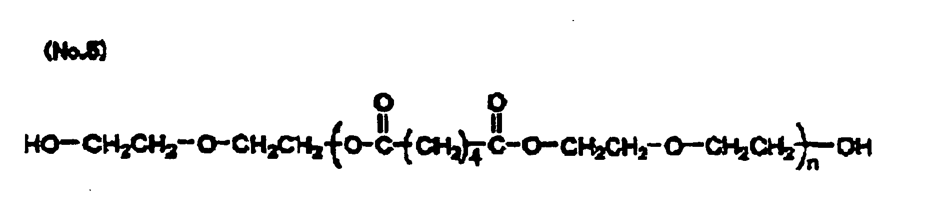

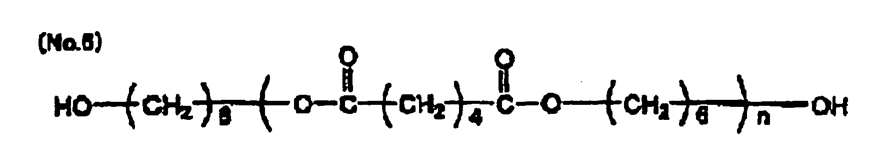

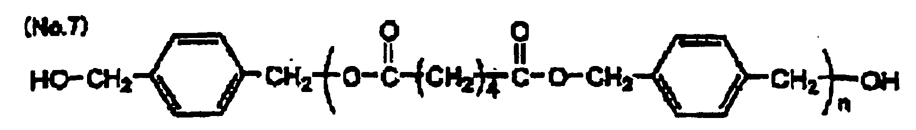

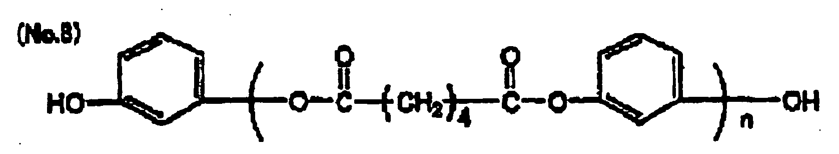

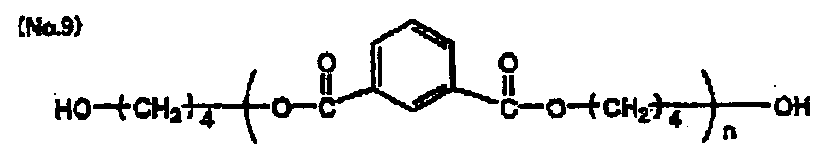

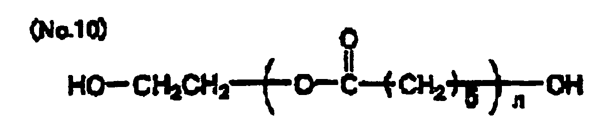

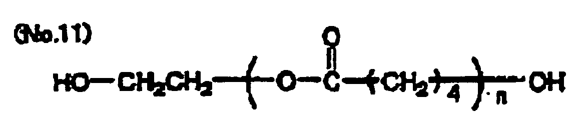

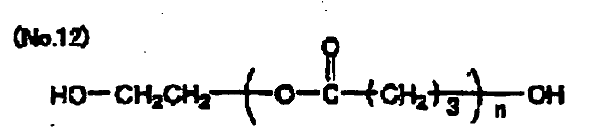

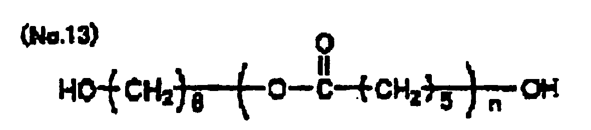

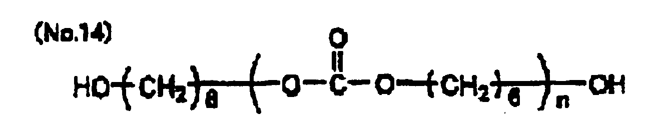

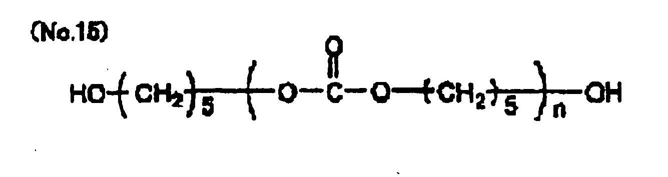

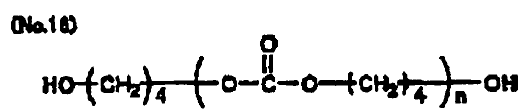

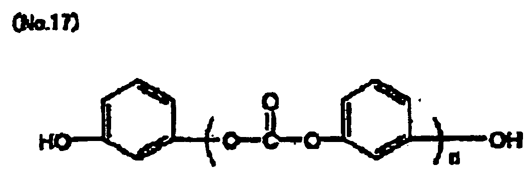

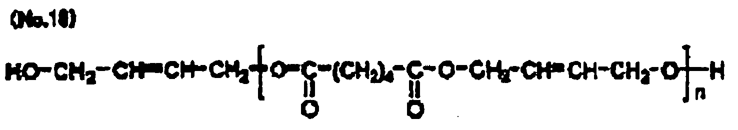

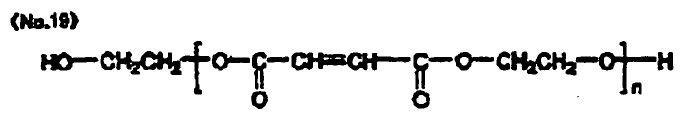

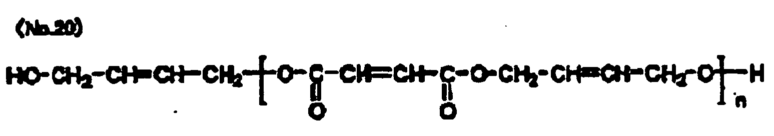

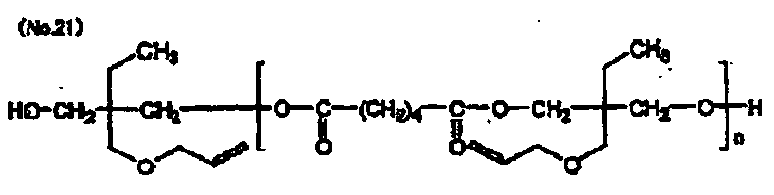

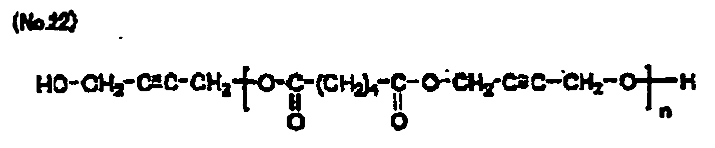

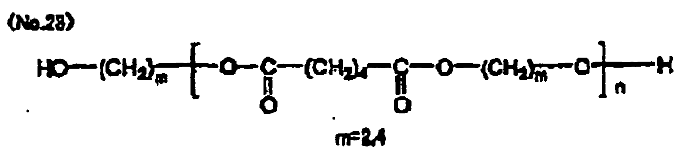

Moreover, a diol compound that does not have a carboxy group and that may have other functional group which does not react with the isocyanate group may be used.

Examples of such a diol compound include those represented by formulae (14) and (15) shown below.
HO-L₆-O-CO-L₇-CO-O-L₆-OH (14)
HO-L₇-CO-O-L₆-OH (15)

In the formulae, L₆ and L₇, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₆ and L₇ each may have other functional group which does not react with the isocyanate group, for example, a carbonyl group, an ester group, a urethane group, an amido group or a ureido group, if desired. Alternatively, L₆ and L₇ may be combined with each other to form a ring.

Specific examples of the diol compound represented by formula (14) or (15) include those shown below.

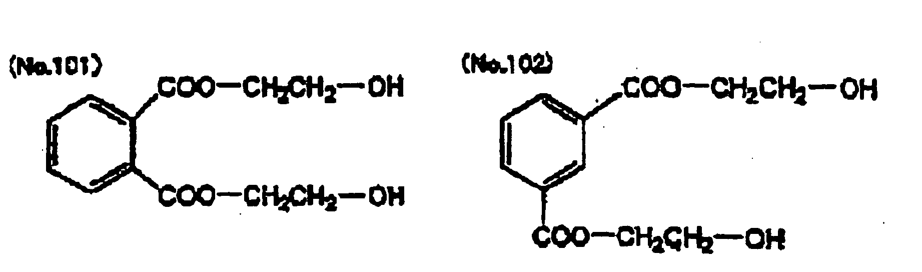

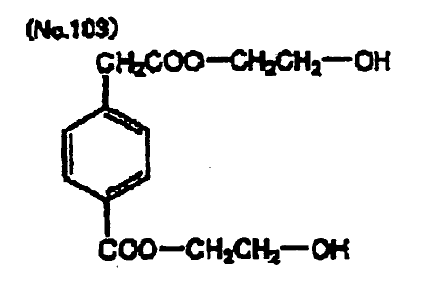

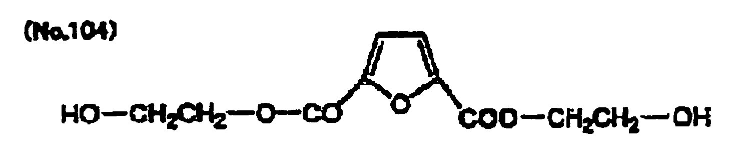

(No.105) HO-CH₂CH₂-O-CO-CH=CH-COO-CH₂CH₂-OH

(No.106) HO-OH₂CH₂-O-COO₁₁H₂₂COO-CH₂CH₂-OH

(No.107) HO-CH₂CH₂-O-COC₁₂H₂₄COO-CH₂CH₂-OH

(No.108) HO-CH₂CH₂-O-COC₁₄H₂₈COO-CH₂CH₂-OH

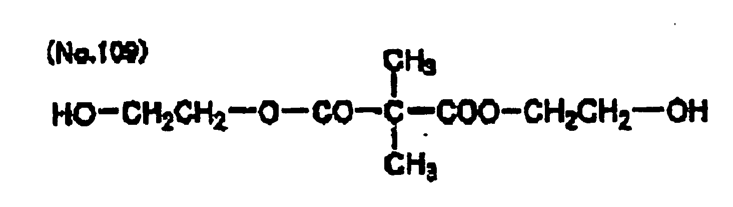

(No.110) HO-CH₂CH₂-O-CO-C=C-COO-CH₂CH₂-OH

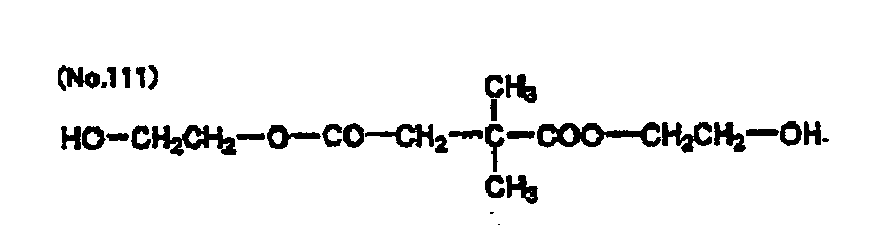

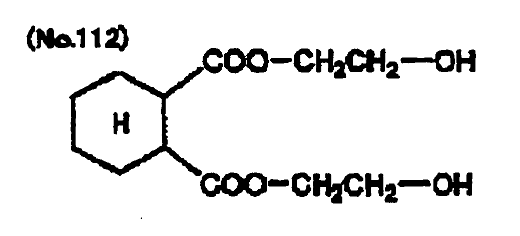

(No.113) HO-CH₂CH₂-O-CO-CH₂-O-CH₂-COO-CH₂CH₂-OH

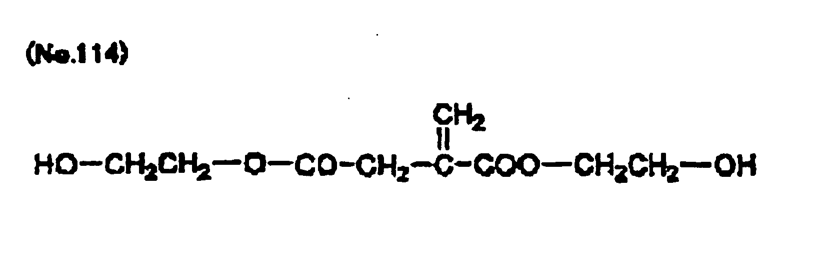

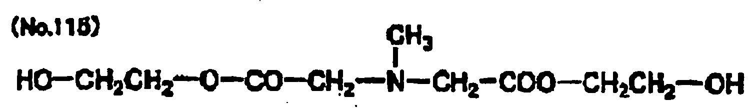

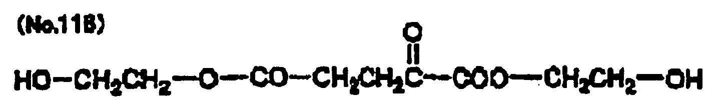

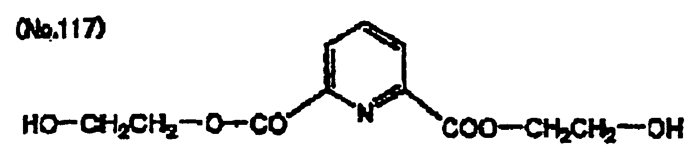

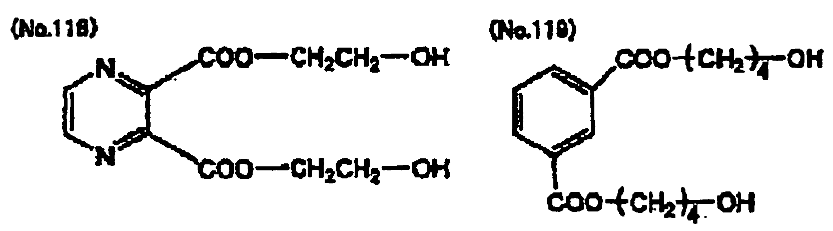

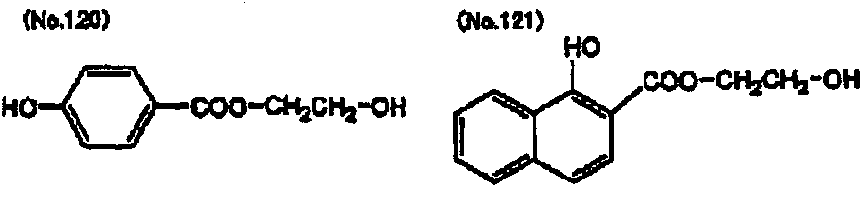

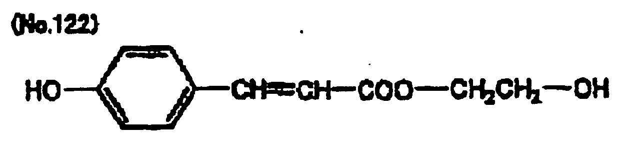

(No.123) HO-CH₂CH₂-COO-CH₂CH₂-OH

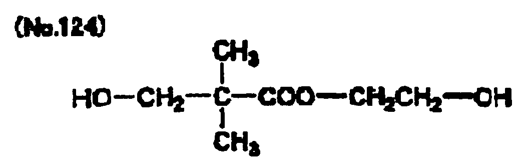

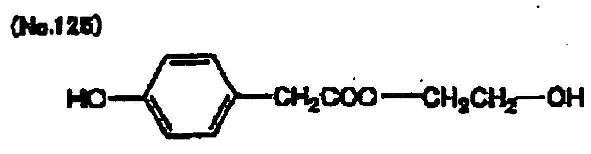

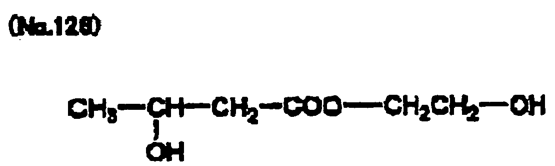

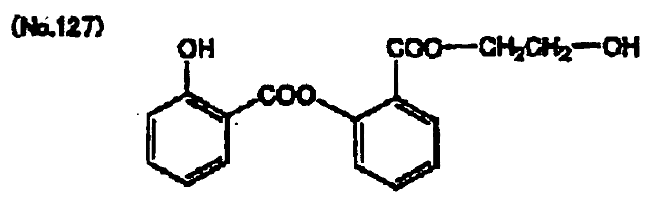

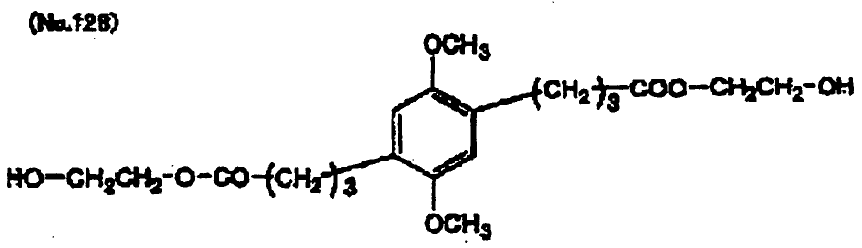

Moreover, diol compounds shown below are also preferably used. 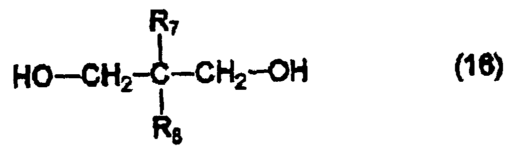 HO-CH₂-C≡C-CH2-OH (17)
HO-CH₂-CH=CH-CH₂-OH (18)

In the formulae, R₇ and R₈, which may be the same or different, each represents an alkyl group which may have a substituent, preferably an alkyl group having from 1 to 10 carbon atoms which may have a substituent (for example, a cyano group, a nitro group, a halogen atom (e.g., -F, -Cl, -Br or -I), -CONH₂, -COOR or -OR (wherein R, which may be the same or different, each represents an alkyl group having from 1 to 10 carbon atoms, an aryl group having from 7 to 15 carbon atoms or an aralkyl group)).

Specific examples of the diol compound represented by formula (16) include those shown below.

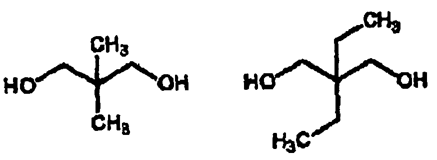

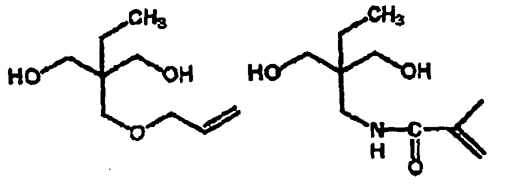

Example of the diol compound represented by formula (17) includes 2-butyne-1,4-diol. Examples of the diol compound represented by formula (18) include cis-2-butene-1,4-diol and trans-2-butene-1,4-diol.

Furthermore, diol compounds represented by formulae (19) and (20) shown below are also preferably used.
HO-L₈-NH-CO-L₉-CO-NH-L₈-OH (19)
HO-L₉-CO-NH-L₈-OH (20)

In the formulae, L₈ and L₉, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₅ and L₉ each may have other functional group which does not react with the isocyanate group, for example, a carbonyl group, an ester group, a urethane group, an amido group or a ureido group, if desired. Alternatively, L₈ and L₉ may be combined with each other to form a ring.

Specific examples of the diol compound represented by formula (19) or (20) include those shown below. 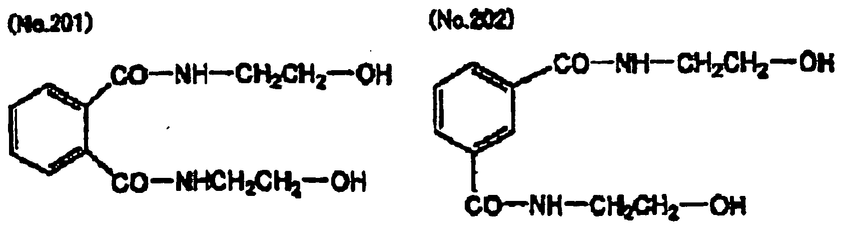 (No.203) HO-CH₂CH₂-NH-CO-CH=CH-CO-NH-CH₂CH₂-OH
(No.204) HO-CH₂CH₂-NH-CO-C=C-CO-NH-CH₂CH₂-OH

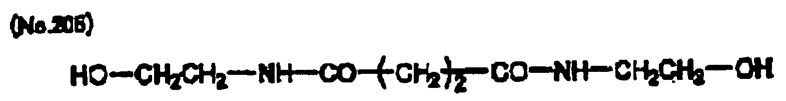

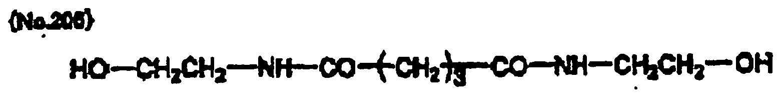

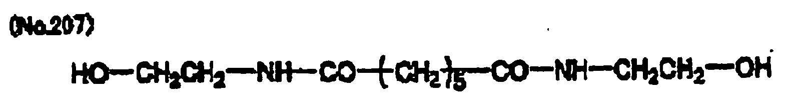

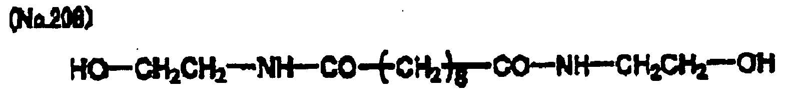

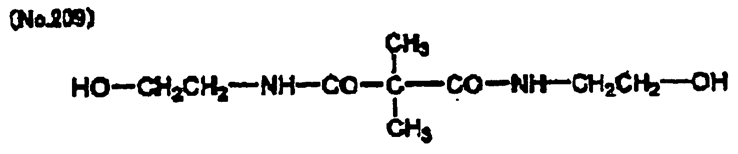

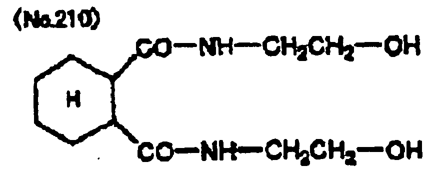

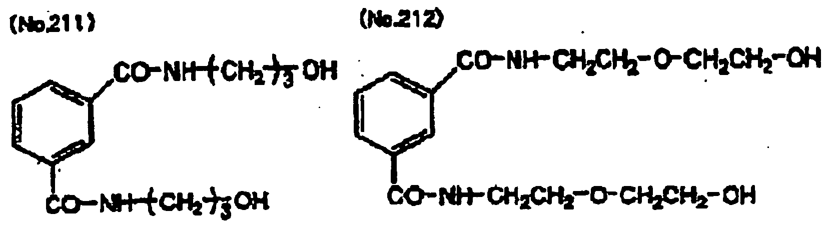

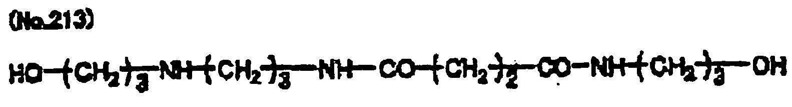

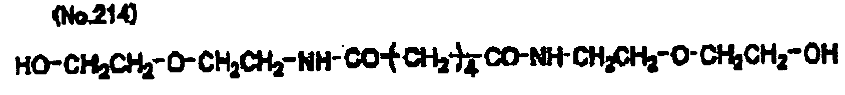

(No.215) HO-CH₂CH₂-NH-CO-CH₂-O-CH₂-CO-NH-CH₂CH₂-OH

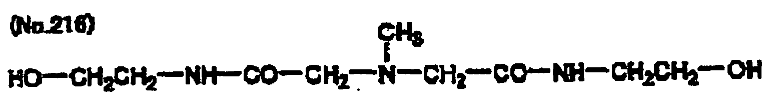

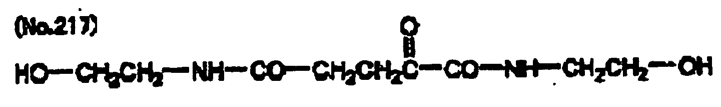

(No. 218) HO-CH₂CH₂-NH-CO-CH₂-S-CH₂-CO-NH-CH₂CH₂-OH

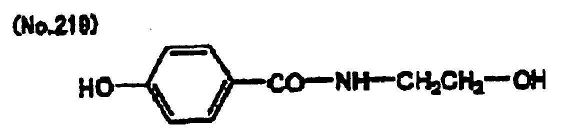

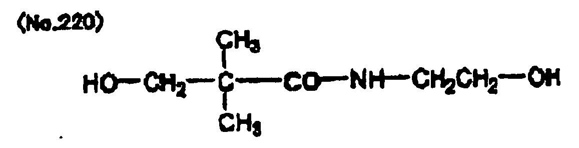

Furthermore, diol compounds represented by formulae (21) and (22) shown below are also preferably used.

HO₋Ar₂-(L₁₆-Ar₃)ₙ-OH (21)

HO-Ar₂-L₁₆-OH (22)

In the formulae, L₁₆ represents a divalent aliphatic hydrocarbon group which may have a substituent (for example, an alkyl group, an aralkyl group, an aryl group, an alkoxy group, an aryloxy group or a halogen atom). L₁₆ may have other functional group which does not react with the isocyanate group, for example, an ester group, a urethane group, an amido group or a ureido group, if desired.

Ar₂ and Ar₃, which may be the same or different, each represents a divalent aromatic hydrocarbon group which may have a substituent, preferably an aromatic group having from 6 to 15 carbon atoms. n represents an integer of 0 to 10.

Specific examples of the diol compound represented by formula (21) or (22) include those shown below.

Specifically, catechol, resorcine, hydroquinone, 4-methylcatechol, 4-tert-butylcatechol, 4-acetylcatechol, 3-methoxycatechol, 4-phenylcatechol, 4-methylresorcine, 4-ethylresorcine, 4-tert-butylresorcine, 4-hexylresorcine, 4-chlororesorcine, 4-benzylresorcine, 4-acetylresorcine, 4-carboxymethoxyresorcine, 2-methylresorcine, 5-methylresorcine, tert-butylhydroquinone, 2,5-di-tert-butylhydroquinone, 2,5-di-tert-amylhydroquinone, tetramethylhydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybezyl alcohol, 4-hydroxybezyl alcohol, 2-hydroxy-3,5-di-tert-butylbezyl alcohol, 4-hydroxy-3,5-di-tert-butylbezyl alcohol, 4-hydroxyphenethyl alcohol, 2-hydroxyethyl-4-hydroxybenzoate, 2-hydroxyethyl-4-hydroxyphenylacetate and resorcine mono-2-hydroxyethyl ether are exemplified. Diol compounds shown below are also preferably used.

### (v) Other Amino Group-Containing Compound

In the polyurethane resin binder according to the invention, an amino group-containing compound represented by formula (31) or (32) shown below may be used together to react with the diisocyanate compound, thereby forming a urea structure to incorporate into the polyurethane resin.

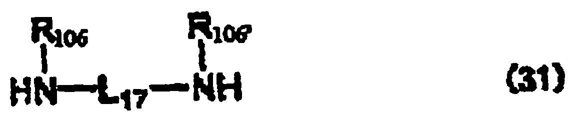

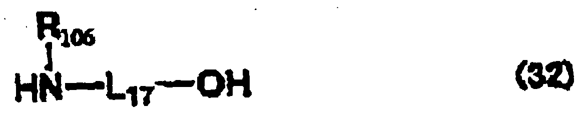

In the formulae, R₁₀₆ and R₁₀₆', which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxy group); and preferably a hydrogen atom, an alkyl group having from 1 to 8 carbon atoms or an aryl group having from 6 to 15 carbon atoms, each of which may have a carboxy group as a substituent. L₁₇ represents a divalent aliphatic hydrocarbon group, aromatic hydrocarbon group or heterocyclic group, each of which may have a substituent (for example, an alkyl group, an aralkyl group, an aryl goup, an alkoxy group, an aryloxy group, a halogen atom (e.g., -F, -Cl, -Br or -I) or a carboxy group). L₁₇ may have other functional group which does not react with the isocyanate group, for example, a carbonyl group, an ester group, a urethane group or an amido group, if desired. Alternatively, two of R₁₀₆, L₁₇ and R₁₀₆ may be combined with each other to form a ring.

Specific examples of the compound represented by formula (31) or (32) include the following compounds.

Specifically, aliphatic diamine compounds, for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminoprapyl)methylamine, 1,3-bis(3-aminopropyl)tetramethylsiloxane, piperazine, 2,5-dimethylpiperazine, N-(2-aminoethyl)pipexazine, 4-amino-2,2,6,6-tetramethylpiperidine, N,N-dimethylethylenediamine, lysine, L-cystine or isophorondiamine); aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, - 4,4'-diaminophenyl ether or 1,8-naphthalenediamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryptophan or adenine; and aminoalcohol or aminophenol compounds, for example, ethanolamine, N-methylethaoolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol or L-tyrosine are enumerated.

A polyurethane resin obtained by introducing a crosslinkable group into polyurethane having a carboxy group by a polymer reaction as described in JP-A-2003-270775 may also be used as the polymer binder according to the invention as well as the above-described polyurethane resin obtained by introducing a crosslinkable group into a side chain at the synthesis of polyurethane.

A molecular weight of the polymer binder used in the invention is appropriately determined in view of the image-forming property and printing durability. The molecular weight is from 10,000 to 200,000.

The polymer binders may be used individually or in combination of two or more thereof in the invention. Further, the polymer binder according to the invention may be used together with one or more other binder polymers having no crosslinkable group. As the binder polymer used together, conventionally known alkali-soluble or alkali-swellable binders are employed without any limitation. Specifically, for example, acryl main chain binders and urethane binders conventionally used in the field of art can be preferably employed.

The total amount of the polymer binder and binder polymer which may be used together in the photosensitive layer can be appropriately determined. It is, however, ordinarily in a range from 10 to 90% by weight, preferably from 20 to 80% by weight, and more preferably from 30 to 70% by weight, based on the total weight of the nonvolatile components in the photosensitive layer.

### (E) Chain Transfer Agent

It is preferred that the photosensitive layer according to the invention contains a chain transfer agent. The chain transfer agent contributes to improvements in the sensitivity and preservation stability. Compounds which function as the chain transfer agents include, for example, compounds containing SH, PH, SiH or GeH in their molecules. Such a compound donates hydrogen to a radical species of low activity to generate a radical, or is oxidized and then deprotonated to generate a radical.

In the photosensitive layer according to the invention, a thiol compound (for example, a 2-mercaptobenzimidazole) is particularly preferably used as the chain transfer agent.

Among them, a thiol compound represented by formula (II) shown below is particularly preferably used. By using the thiol compound represented by formula (II) as the chain transfer agent, a problem of the odor and decrease in sensitivity due to evaporation of the compound from the photosensitive layer or diffusion thereof into other layers are avoided and a lithographic printing plate precursor which is excellent in preservation stability and exhibits high sensitivity and good printing durability is obtained.

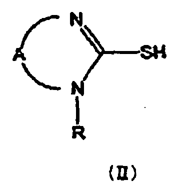

In formula (II), R represents an alkyl group which may have a substituent or an aryl group which may have a substituent; and A represents an atomic group necessary for forming a 5-membered or 6-membered hetero ring containing a carbon atom together with the N=C-N linkage, and A may have a substituent.

Compounds represented by formulae (IV) and (V) shown below are more preferably used.

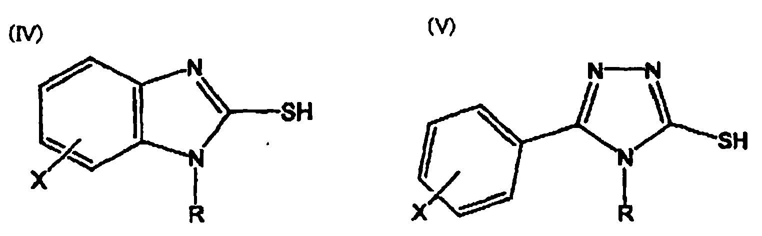

In formulae (IV) and (V), R represents an alkyl group which may have a substituent or an aryl group which may have a substituent; and X represents a halogen atom, an alkoxy group which may have a substituent, an alkyl group which may have a substituent or an aryl group which may have a substituent.

Specific examples of the compound represented by formula (II) are set forth below, but the invention should not be construed as being limited thereto.

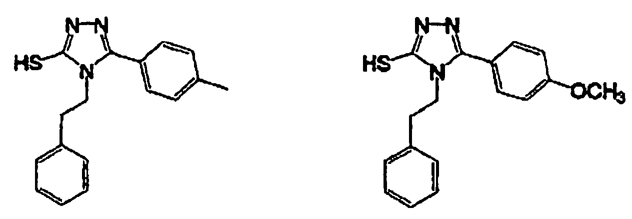

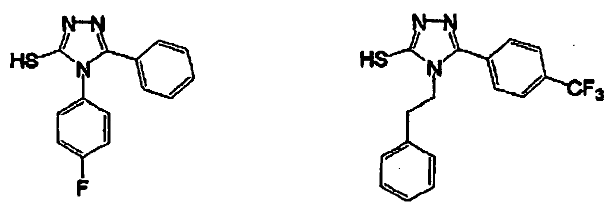

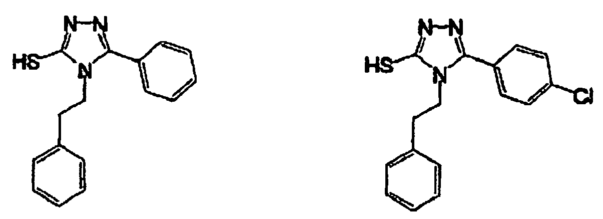

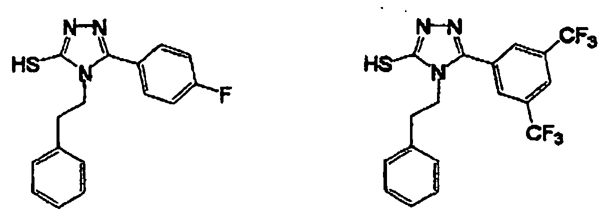

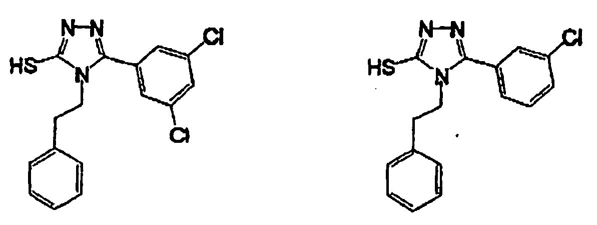

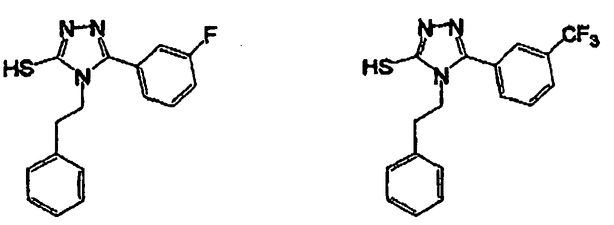

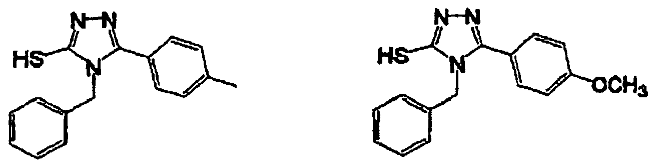

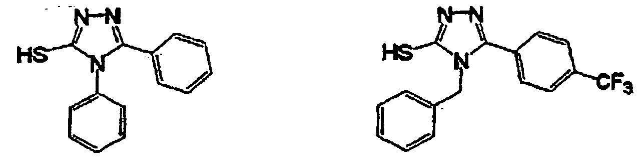

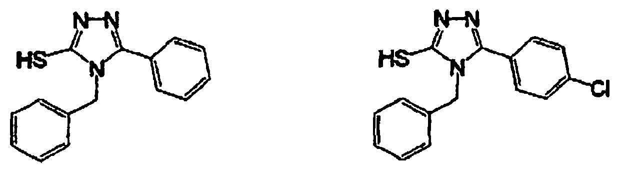

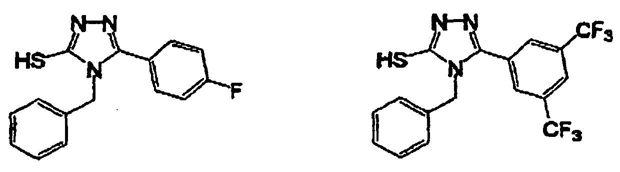

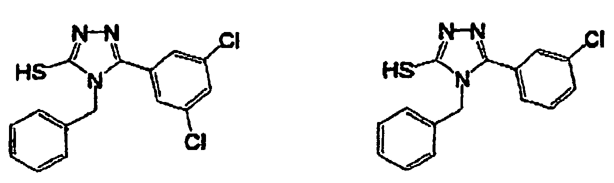

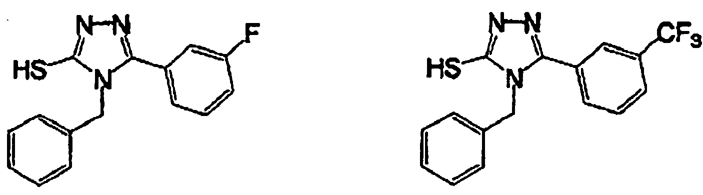

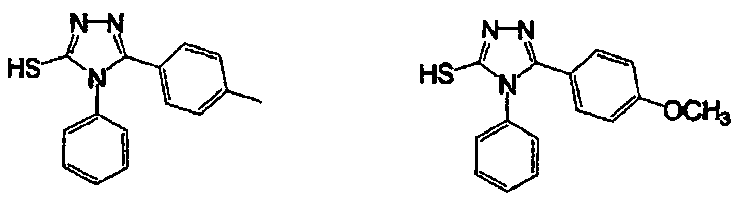

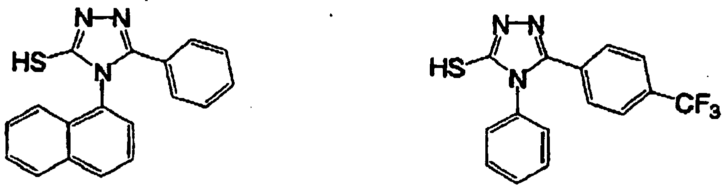

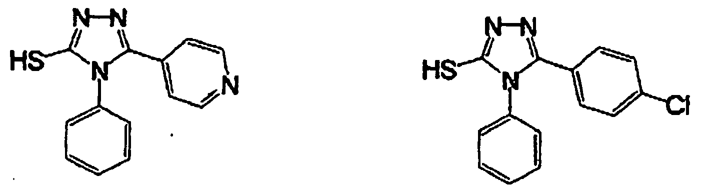

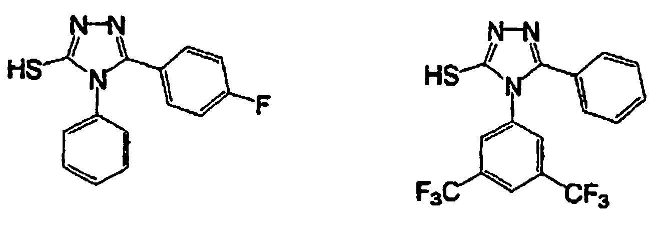

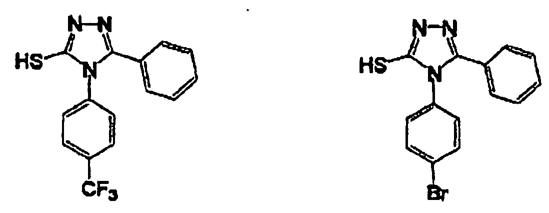

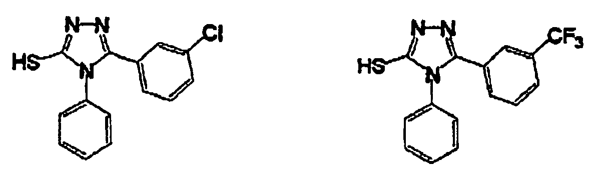

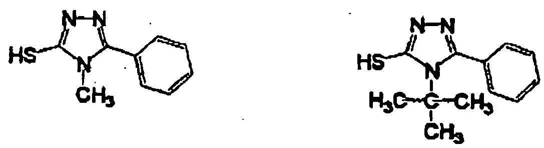

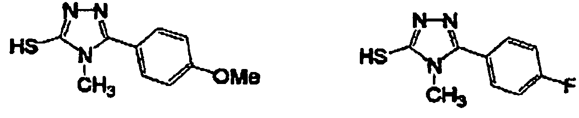

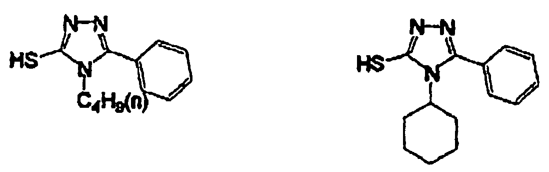

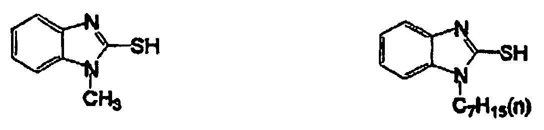

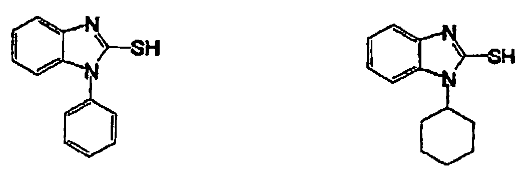

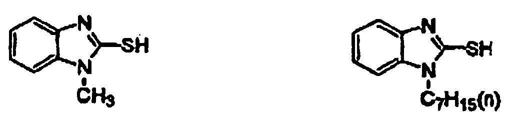

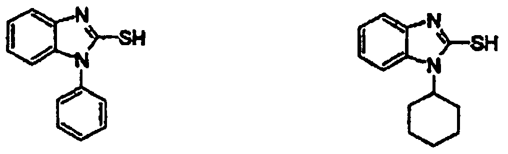

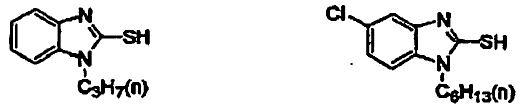

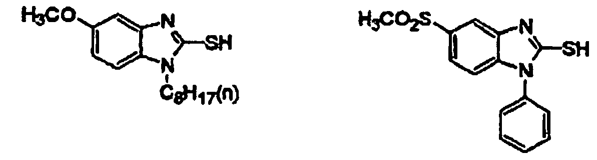

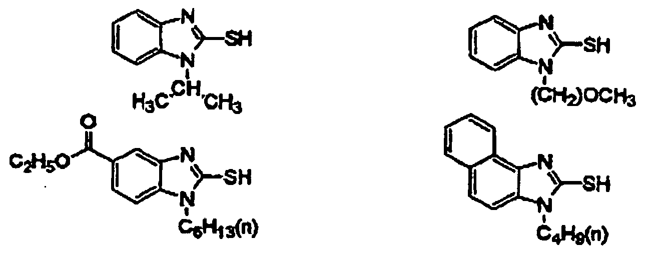

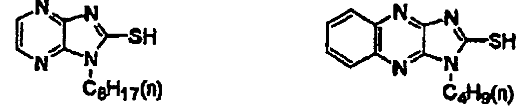

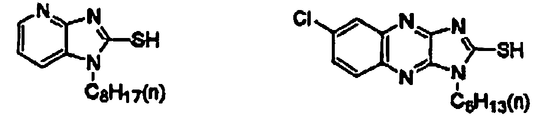

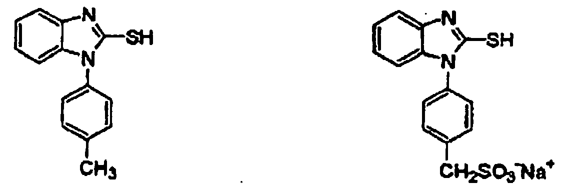

An amount of the chain transfer agent (for example, the thiol compound) used is preferably from 0.01 to 20% by weight, more preferably from 0.1 to 15% by weight, still more preferably from 1.0 to 10% by weight, based on the total solid content of the photosensitive layer.

### (F) Other Additives

It is preferred to add a small amount of a thermal polymerization inhibitor to the photosensitive layer, in order to prevent undesirable thermal polymerization in the photosensitive layer during the production or preservation of the lithographic printing plate precursor. Suitable examples of the thermal polymerization inhibitor include hydroquinone, p-methoxyphenol, di-tert-butyl-p-cresol, pyrogallol, tert-butylcatechol, benzoquinone, 4,4-thiobis(3-methyl-6-tert-butylphenol), 2,2'-methylenebis(4-methyl-6-tert-butylphenol), N-nitrosophenylhydroxyamine cerium(III) salt and N-nitrosophenylhydroxylamine aluminum salt.

The amount of the thermal polymerization inhibitor added is preferably from about 0.01 to about 5% by weight, based on the total solid content of the photosensitive layer.

If desired, in order to avoid polymerization inhibition due to oxygen, a higher fatty acid derivative, for example, behenic acid or behenic amide may be added and allowed to localize on the photosensitive layer surface during the drying step after the coating thereof The amount of the higher fatty acid derivative added is preferably from about 0.5 to about 10% by weight based on the total solid content of the photosensitive layer.

Further, for the purpose of coloring the photosensitive layer, a coloring agent may be added. Examples of the coloring agent include phthalocyanine pigments (for example, C.I. Pigment Blue 15:3, C.I. Pigment Blue 15:4 or C.I. Pigment Blue 15:6), azo pigments, pigments, for example, carbon black or titanium oxide, Ethyl Violet, Crystal Violet, azo dyes, anthraquinone dyes and cyanine dyes. The amount of the dye or pigment added is preferably from about 0.5 to about 20% by weight based on the total solid content of the photosensitive layer. In addition, for the purpose of improving physical properties of the cured film, an additive, for example, an inorganic filler or a plasticizer, for example, dioctyl phthalate, dimethyl phthalate or tricresyl phosphate may be added. The amount of the additive added is preferably 10% by weight or less based on the total solid content of the photosensitive layer.

### [Formation of Photosensitive Layer]

In the coating of the photosensitive layer, each of the components described above is dissolved in a solvent to prepare a coating solution. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propyolene glycol monoethyl ether acetate, 3-methoxypropyl acetate, N',N-dimethylformamide, dimethylsulfoxide, y-butyrolactone, methyl lactate and ethyl lactate. The solvents may be used individually or as a mixture thereof

The concentration of the solid content in the coating solution is ordinarily from 1 to 50% by weight.

Further, in order to improve surface quality of the coating, a surfactant may be added to the coating solution.

The coverage of the photosensitive layer is ordinarily from about 0.1 to about 10 g/m², preferably from 0.3 to 5 g/m², and more preferably from 0.5 to 3 g/m², in terms of weight after drying.

### [Protective Layer]

It is preferred that in the lithographic printing plate precursor of the invention, a protective layer (oxygen-block layer) is provided on the photosensitive layer in order to prevent diffusion and penetration of oxygen which binders the polymerization reaction at the time of exposure. The protective layer for use in the invention preferably has oxygen permeability (A) at 25°C under 1 atmosphere of 1.0 ≤ A ≤ 20 (ml/m²·day). When the oxygen permeability (A) is extremely lower than 1.0 (ml/m².day), problems may occur in that an undesirable polymerization reaction arises during the production or preservation before imagewise exposure and in that undesirable fog or spread of image line generates at the image exposure. On the contrary, when the oxygen permeability (A) greatly exceeds 20 (ml/m²·day), decrease in sensitivity may occur. The oxygen permeability (A) is more preferably in a range of 1.5 ≤ A ≤ 12 (ml/m²·day), and still more preferably in a range of 2.0 ≤ A ≤ 8.0 (ml/m²·day). Besides the above described oxygen permeability, as for the characteristics required of the protective layer, it is preferred that the protective layer does not substantially hinder the transmission of light for exposure, is excellent in adhesion to the photosensitive layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in fundamental characteristics, for example, oxygen-shielding property and removability of the protective layer by development.

Polyvinyl alcohol for use in the protective layer may be partially substituted with ester, ether or acetal as long as it contains unsubstituted vinyl alcohol units for achieving the necessary oxygen-shielding property and water solubility. Also, a part of polyvinyl alcohol may have other copolymer component. As specific examples of polyvinyl alcohol, those having a hydrolyzing rate of 71 to 100% and a polymerization repeating unit number of 300 to 2,400 are exemplified. Specific examples thereof include PVA-105, PVA-110, PVA-117, PVA-117H, PVA-120, PVA-124, PVA-124K PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA.-420, P'VA-613 and L-8 (manufactured by Kuraray Co., Ltd.). They can be used individually or as a mixture. According to a preferred embodiment, the content of polyvinyl alcohol in the protective layer is from 20 to 95% by weight, more preferably from 30 to 90% by weight.

As a component used as a mixture with polyvinyl alcohol, polyvinyl pyrrolidone or a modified product thereof is preferred from the viewpoint of the oxygen-shielding property and removability by development. The content thereof is ordinarily from 3.5 to 80% by weight, preferably from 10 to 60% by weight, more preferably from 15 to 30% by weight.

The components of the protective layer (the selection of PVA and the use of additives) and the coating amount are selected taking into consideration fogging characteristic, adhesion and scratch resistance besides the oxygen-shielding property and removability by development. In general, the higher the hydrolyzing rate of the PVA used (the higher the unsubstituted vinyl alcohol unit content in the protective layer) and the larger the layer thickness, the higher is the oxygen-shielding property, thus advantageous in the point of sensitivity. The molecular weight of the (co)polymer, for example, polyvinyl alcohol (PVA) is ordinarily from 2,000 to 10,000,000, and preferably from 20,000 to 3.,000,000.

As other components of the protective layer, glycerin, dipropylene glycol or the like can be added in an amount corresponding to several % by weight of the (co)polymer to provide flexibility. Further, an anionic surfactant, for example, sodium alkylsulfate or sodium alkylsulfonate; an amphoteric surfactant, for example, alkylaminocarboxylate and alkylaminodicarboxylate; or a nonionic surfactant, for example, polyoxyethylene alkyl phenyl ether can be added in an amount corresponding to several % by weight of the (co)polymer. The thickness of the protective layer is suitably from 0.5 to 5 µm, and particularly preferably from 1 to 3 µm.

The adhesion of the protective layer to the photosensitive layer and scratch resistance are also extremely important in handling of the printing plate. Specifically, when a hydrophilic layer comprising a water-soluble polymer is laminated on a lipophilic photosensitive layer, layer peeling due to insufficient adhesion is liable to occur, and the peeled part causes such a defect as film hardening failure due to polymerization hindrance by oxygen. Various proposals have been made for improving the adhesion between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the photosensitive layer. Any of these known techniques can be applied to the protective layer of the invention. Coating methods of the protective layer are described in detail, for example, in U.S. Patent 3,458,311 and JP-B-55-49729.

A coating amount of the protective layer is ordinarily from 0.1 to 10 g/m², and preferably from 0.5 to 5 g/m², in terms of dry weight.

### [Support]

The support for use in the lithographic printing plate precursor of the invention is not particularly restricted as long as it is a dimensionally stable plate-like material. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film laminated or deposited with the metal described above. A preferred support includes a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials conventionally known and used can be appropriately utilized.

The thickness of the support is preferably from 0. I to 0.6 mm, more preferably from 0.1.5 to 0.4 mm, and still more preferably from 0.2 to 0.3 mm

Prior to the use of aluminum plate, a surface treatment, for example, surface roughening treatment or anodizing treatment is preferably performed. The surface treatment facilitates improvement in the hydrophilic property and assurance of adhesion between the photosensitive layer and the support. Prior to the surface roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, a mechanical roughening treatment, an electrochemical roughening treatment (roughening treatment of electrochemically dissolving the surface) and a chemical roughening treatment (roughening treatment of chemically dissolving the surface selectively).

As the method of the mechanical roughening treatment, a known method, for example, ball grinding, brush grinding, blast grinding or buff grinding can be used.

The electrochemical roughening treatment method includes, for example, a method of applying alternating current or direct current to the aluminum plate in an electrolyte containing an acid, for example, hydrochloric acid or nitric acid. Also, a method of using a mixed acid described in JP-A-54-63902 can be used.

The aluminum plate subjected to the roughening treatment is subjected, if desired, to an alkali etching treatment using an aqueous solution, for example, of potassium hydroxide or sodium hydroxide and further subjected to a neutralizing treatment, and then subjected to an anodizing treatment in order to improve the abrasion resistance of the aluminum plate, if desired.

As the electrolyte used for the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte used.

Since the conditions for the anodizing treatment are varied depending on the electrolyte used, they cannot be defined commonly. However, it is ordinarily preferred that electrolyte concentration in the solution is from 1 to 80% by weight, liquid temperature is from 5 to 70°C, current density is from 5 to 60 A/dm², voltage is from 1 to 100 V, and electrolysis time is from 10 seconds to 5 minutes. The amount of the anodized film formed is preferably from 1.0 to 5.0 g/m² and more preferably from 1.5 to 4.0 g/m². In the range, good printing durability and favorable scratch resistance in the non-image area of lithographic printing plate can be achieved.

After conducting the anodizing treatment, the surface of the aluminum plate is subjected to a hydrophilizing treatment, if desired. The hydrophilizing treatment includes an alkali metal silicate method described in U.S. Patents 2,714,066, 3,181,461, 3,280,734 and 3,902,734. In the method, the support is subjected to immersion treatment or electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461 and 4,689,272.

The support preferably has a center line average roughness of 0.10 to 1.2 µm. In the range, good adhesion with the photosensitive layer, good printing durability and good resistance to stain can be achieved.

Further, color density of the support is preferably from 0.15 to 0.65 in terms of a reflection density value. In the range, good image-forming property due to prevention of halation at the image exposure and good plate inspection property after development can be achieved.

### [Intermediate layer]

According to the invention, after performing the above described treatments, an intermediate layer (also referred to as an undercoat layer, sometimes) may be provided for the purpose of improving the adhesion between the photosensitive layer and the support and improving the stain resistance. For instance, the support undercoated with a water-soluble resin, for example, polyvinylphosphonic acid, a polymer or copolymer having a sulfo group in the side chain thereof or polyacryic acid, a water-soluble metal salt, for example, zinc borate, a yellow dye or an amine salt is preferably used. Moreover, a sol-gel treated substrate to which a functional group capable of causing an addition reaction with a radical is connected via a covalent bond as described in JP-A-7-159983 is preferably used.

Other preferred examples include a support obtained by providing a water-resistant hydrophilic layer as a surface layer on an appropriate support. Examples of the surface layer include a layer comprising an inorganic pigment and a binder described in U.S. Patent 3,055,295 and IP-A-56-13168, a hydrophilic swellable layer described in JP-A-9-80744, and a sol-gel film comprising titanium oxide, polyvinyl alcohol and a silicic acid described in JP-T-8-507727 (The term "JP-T" as used herein means a published Japanese translation of a PCT patent application). The hydrophilizing treatment is conducted for the purpose of rendering the surface of the support hydrophilic, and for the purpose of preventing harmful reactions of the photosensitive layer provided thereon and improving adhesion to the photosensitive layer.

Other examples of the intermediate layer include those described, for example, in JP-B-50-7481, JP-A-54-72104, JP-A-59-101651, JP-A-60-149491 JP-A-60-232998 JP-A-3-56177, , JP-A-4-282637, , JP-A-5-16558, JP-A-5-246171, JP-A-7-314937, JP-A-8-202025, JP-A-8-320551, JP-A-9-34104, JP-A-9-236911, JP-A-9-269593, JP-A-10-69092, JP-A 10-115931, JP-A-10-161317, JP-A-10-260S36, JP-A-10-282682, JP-A-11-84674, JP-A-11-38635, JP-A-11-38629, JP-A-10-282645, JP-A-10-301262, JP-A-11-24277, JP-A-11-109641, JP-A-10-319600, JP-A-11-327152, JP-A-2000-10292, JP-A 2000-235254, JP-A-2000-352824 and IP-A-2001-209170.

### [Backcoat]

After performing the surface treatments on the support or forming the intermediate layer on the support, a backcoat may be provided on the rear surface of the support, if desired.

The backcoat preferably includes, for example, a coating layer comprising an organic polymer compound described in JP-A-5-45885 and a coating layer comprising a metal oxide obtained by hydrolysis and polycondensation of an organic metallic compound or inorganic metallic compound. Among them, an alkoxy compound of silicon, for example, Si(OCH₃)₄, Si(O(₄H₅)₄ Si(OC₃H₇)₄ or Si(OC₄H₉)₄ is preferably used, since the starting materials thereof are not expensive and easily available.

### [Plate-Making Method]

Now, a plate-making method of the photosensitive lithographic printing plate according to the invention will be described in detail. The photosensitive lithographic printing plate precursor is imagewise exposed and then developed with an aqueous alkali solution. The developer for use in the plate-making method according to the invention is described below.

### (Developer)

The developer for use in the plate-making method according to the invention is not particularly restricted. However, for example, a solution containing an inorganic alkali salt and a nonionic surfactant and having a pH of from 11.0 to 12.7 is preferably used.

The inorganic alkali salt is appropriately used. Examples thereof include an inorganic alkali agent, for example, sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. The inorganic alkali salts may be used individually or in combination of two or more thereof.

In the case of using the silicate, developing property can be easily adjusted by selecting a mixing ratio of silicon oxide (SiO₂) to alkali oxide (M₂O (wherein M represents an alkali metal or an ammonium group)), which are the components of the silicate, and the concentration thereof Of the aqueous alkali solutions, an aqueous alkali solution having the mixing ratio of silicon oxide (SiO₂) to alkali oxide (M₂O) (SiO₂/M₂O in molar ratio) of from 0.5 to 3.0 is preferred, and that of from 1.0 to 2.0 is more preferred. The amount of the SiO₂/M₂O added is preferably from 1 to 10% by weight, more preferably from 3 to 8% by weight, most preferably from 4 to 7% by weight, based on the weight of the aqueous alkali solution. When the concentration is in the above-described range, there arise no reduction in the developing property and processing ability, no formation of precipitates and crystals, and no gelation at neutralization of waste liquor of the developer, thereby causing no troubles in treatment of the waste liquor.

Also, an organic alkali agent may be supplementarily used for the purposes of delicate adjustment of alkali concentration and of assisting dissolution of the photosensitive layer. Examples of the organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The organic alkali agents may be used individually or in combination of two or more thereof

The surfactant is appropriately used. Examples thereof include nonionic surfactants, for example, a nonionic surfactant having a polyoxyalkylene ether group, a polyoxyethylene alkyl ester (e.g., polyoxyethylene stearate), a sorbitan alkyl ester (e.g., sorbitan monolaurate, sorbitan monostearate, sorbitan distearate, sorbitan monooleate, sorbitan sesquioleate or sorbitan trioleate) and a monoglyceride alkyl ester (e.g., glycerol monostearate or glycerol monooleate); anionic surfactants, for example, an alkylbenzenesulfonate (e.g., sodium dodecylbenzenesulfonate), an alkylnaphthalenesulfonate (e.g., sodium butyinaphthalenesulfonate, sodium pentylnaphthalenesulfonate, sodium hexylnaphthalenesulfonate or sodium octybiaphthalenesulfonate), an alkylsulfate (e.g., sodium laurylsulfate), an alkylsulfonate (e.g., sodium dodecylsulfonate) and a sulfosuccinic acid ester salt (e.g., sodium dilaurylsulfosuccinate); and amphoteric surfactants, for example, an alkylbetaine (e.g., laurylbetaine or stearylbetaine) and an amino acid. Nonionic surfactants having a polyoxyalkylene ether group are particularly preferred.

As the surfactant having a polyoxyalkylene ether group, compounds having the structure represented by formula (VI) shown below are preferably used.

R₄₀-O-(R₄₁-O)ₚH (VI)

In the formula, R₄₀ represents an alkyl group having from 3 to 15 carbon atoms, an aromatic hydrocarbon group having from 6 to 15 carbon atoms or a heteroaromatic ring group having from 4 to 15 carbon atoms. Each of these groups may have a substituent, and examples of the substituent include an alkylene group having from 1 to 20 carbon atoms, a halogen atom, e.g., Br, Cl or I, an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms and an acyl group having from 2 to 15 carbon atoms. R₄₁ represents an alkylene group having from 1 to 100 carbon atoms which may have a substituent. Examples of the substituent include an alkyl group having from 1 to 20 carbon atoms and an aromatic hydrocarbon group having from 6 to 15 carbon atoms, p represents an integer of 1 to 100.

In the definition of the formula (VI), specific examples of the "aromatic hydrocarbon group" include a phenyl group, a tolyl group, a naphthyl group, an anthryl group, a biphenyl group and a phenanthryl group, and specific examples of the "heteroaromatic ring group" include a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group and a benzimidazolyl group.

Also, the moiety of (R₄₁-O)p in the formula (VI) may comprise two or three kinds of groups within the above-described scope. Specifically, there may be illustrated a random or block chain of a combination of ethyleneoxy group and propyleneoxy group, a combination of ethyleneoxy group and isopropyleneoxy group, a combination of ethyleneoxy group and butyleneoxy group, and a combination of ethyleneoxy group and isobutyleneoxy group. In the invention, the surfactants having polyoxyalkylene ether group are used individually or in combination thereof. The surfactant is effectively added in an amount from 1 to 30% by weight, preferably from 2 to 20% by weight, to the developer. When the amount of surfactant added is too small, the developing property may be deteriorated. On the other hand, when the amount is too large, development damage becomes increases and the printing durability of a printing plate may decrease.

Examples of the nonionic surfactant having polyoxyalkylene ether group represented by formula (VI) include a polyoxyethylene alkyl ether, e.g., polyoxyethylene lauryl ether, polyoxyethylene cetyl ether or polyoxyethylene stearyl ether; a polyoxyethylene aryl ether, e.g., polyoxyethylene phenyl ether or polyoxyethylene naphthyl ether; and a polyoxyethylene alkylaryl ether, e.g., polyoxyethylene methylphenyl ether, polyoxyethylene octylphenyl ether or polyoxyethylene nonylphenyl ether.

The surfactants can be used individually or in combination thereof. Also, the amount of the surfactant used in the developer is preferably in the range from 0.1 to 20% by weight in terms of the solid content.

The pH of the developer used in the plate-making method according to the invention is ordinarily from 11.0 to 12.7, preferably from 11.5 to 12.5, in view of the image formation and the damage of the exposed area in the development.

The electric conductivity of the developer used in the invention is preferably from 3 to 30 mS/cm. When it is less than the lower limit, dissolution of the photosensitive layer composition on the aluminum plate support surface becomes difficult, resulting in formation of stain at printing in some cases. On the other hand, when it exceeds the upper limit, due to the high concentration of salt, dissolution rate of the photosensitive layer becomes extremely small, resulting in remaining of the layer in the unexposed area in some cases. The electric conductivity is particularly preferably in the range from 5 to 20 mS/cm.

### (Exposure and Development Processing)

The lithographic printing plate precursor according to the invention is exposed imagewise using a conventionally known active light source, for example, a carbon arc lamp, a high-pressure mercury lamp, a xenon lamp, a metal halide lamp, a fluorescent lamp, a tungsten lamp, a halogen lamp, a helium cadmium laser, an argon ion laser, an FD-YAG laser, a helium neon laser or a semiconductor laser (350 to 600 nm) and then subjected to the development processing with a developer to form an image on the surface of aluminum plate support. As the exposure light source, a laser of 350 to 600 nm is preferable.

It is possible to provide, between the imagewise exposure and the development processing, a process of heating the photosensitive layer at a temperature of 50 to 140°C for 1 second to 5 minutes for the purpose of increasing the curing ratio of the photosensitive layer. The heating at the temperature in the above-described range serves to increase the curing ratio and to prevent the remaining layer in the unexposed area due to dark polymerization.

As described hereinbefore, the protective layer may be provided on the photosensitive layer of the lithographic printing plate precursor according to the invention. There are known a method of removing both the protective layer and the unexposed area of the photosensitive layer at the same time using a developer and a method of first removing the protective layer with water or warm water, and then removing the unexposed area of the photosensitive layer by development. Into the water or warm water may be incorporated an antiseptic as described in rP-A 10-10754 or an organic solvent as described in JP-A-8-278636.

The developer for use in the development processing of the lithographic printing plate precursor according to the invention preferably contains a nonionic surfactant having a polyoxyalkylene ether group.

The development of the lithographic printing plate precursor according to the invention with the above-described developer is conducted in a conventional manner at a temperature from 0 to 60°C, preferably from about 15 to about 40°C, for example, by immersing the exposed lithographic printing plate precursor in the developer and rubbing with a brush.

Further, in the case of conducting the development processing using an automatic developing machine, since the developing solution becomes fatigued in accordance with the processing amount, the processing ability may be restored by using a replenisher or a fresh developer. The thus development-processed lithographic printing plate precursor is after-treated with washing water, a rinse solution containing, for example, a surfactant, or a desensitizing solution containing, for example, gum arabic or a starch derivative as described, for example, in JP-A-54-8002, JP-A-55-1I5045 and JP-A-59-58431. In the after-treatment of the lithographic printing plate precursor according to the invention, these processings may be used in combination.

The printing plate thus-obtained by the above-described processing may be subjected to an after-exposure treatment in the manner as described in JP-A-2000-89478 or a heating treatment, for example, baking, in order to improve the printing durability.

The lithographic printing plate thus-obtained is mounted on an offset printing machine to perform printing of a large number of sheets.

### EXAMPLES

The present invention will be described in more detail with reference to the following examples, but the invention should not be construed as being limited thereto.

### 1: Preparation of Lithographic Printing Plate Precursor

### EXAMPLE 1

### (1) Preparation of Support

A 0.3 mm-thick aluminum plate was etched by dipping in a 10% by weight aqueous sodium hydroxide solution at 60°C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal wavefoim at an anode time electricity of 300 coulomb/dm². Subsequently, the aluminum plate was dipped in a 1% by weight aqueous sodium hydroxide solution at 40°C for 5 seconds, dipped in a 30% by weight aqueous sulfuric acid solution at 60°C for 40 seconds to effect a desmut treatment, and then subjected to an anodizing treatment in a 20% by weight aqueous sulfuric acid solution for 2 minutes at a current density of 2 A/dm² to form an anodic oxide film having a thickness of 2.7 g/m². The surface roughness was measured and found to be 0.3 µm (Ra value according to JIS B0601).

On the aluminum plate thus-treated was coated a coating solution for intermediate layer shown below using a bar coater, followed by drying at 80°C for 20 seconds. A coating amount of the intermediate layer after drying was 10 mg/m²

### Coating Solution for Intermediate Layer

| | | |
|---|---|---|
| | Sol solution shown below | 100 g |
| | Methanol | 900 g |

### Sol Solution

| | | |
|---|---|---|
| | Phosmer PE (produced by Uni-Chemical Co., Ltd) | 5 g |
| | Methanol | 45 g |
| | Water | 10 g |
| | Phosphoric acid (85% by weight) | 5 g |
| | Tetraethoxysilane | 20 g |
| | 3-Methacryloxypropyltrimethoxysilane | 15 g |

### (2) Formation of Photosensitive Layer

Photopolymerizable composition P-1 having the composition shown below was coated on the intermediate layer so as to have a dry coating amount of 1.4 g/m² and dried at 100°C for one minute to form a photosensitive layer.

### Photopolymerizable Cornposition P-1

| | | |
|---|---|---|
| | Polymerizable compound (1) | 4.5 parts by weight |
| | Binder polymer (1) | 5.3 parts by weight |
| | Sensitizing dye (1) | 0.4 parts by weight |
| | Polymerization initiator (1) | 0.9 parts by weight |
| | Chain transfer agent (1) | 0.5 parts by weight |
| | Dispersion of ε-phthalocyanine pigment*¹ | 0.9 parts by weight |
| | Fluorine-based nonionic surfactant (Megafac F780, produced by Dainippon Ink & Chemicals, Inc.) | 0.02 parts by weight |
| | Thermal polymerization inhibitor (N-nitrosophenylhydroxylamine aluminum salt) | 0.03 parts by weight |
| | Methyl ethyl ketone | 58 parts by weight |
| | Propylene glycol monomethyl ether acetate | 53 parts by weight |

| | | |
|---|---|---|
| *¹: Dispersion of ε-phthatocyanine pigment | | |

Dispersion of 15 parts by weight of ε-phthalocyanine pigment, 10 parts by weight of dispersing agent (allyl methacrylate/methacrylic acid copolymer (copolymerization molar ratio: 83/17)) and 15 parts by weight of cyclohexanone

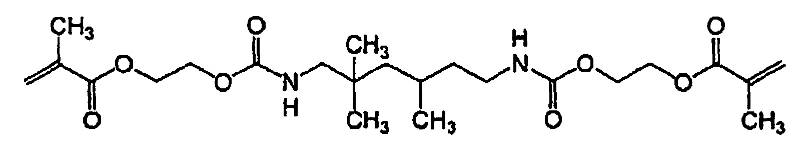

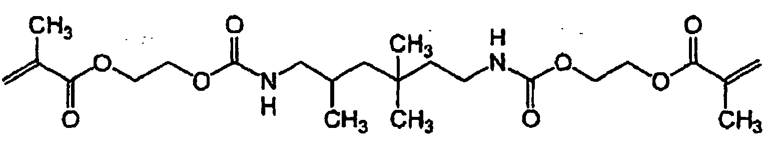

Polymerizable Compound (1) (mixture of the above described isomers)

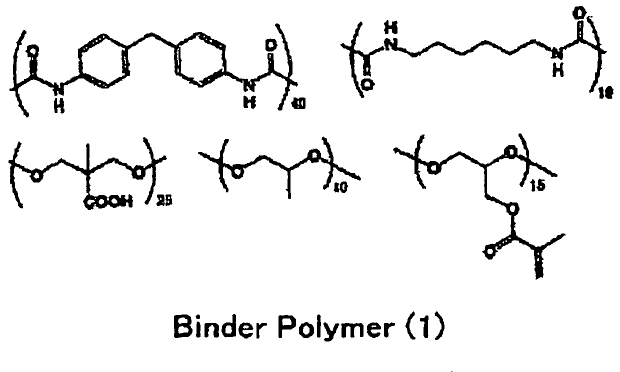

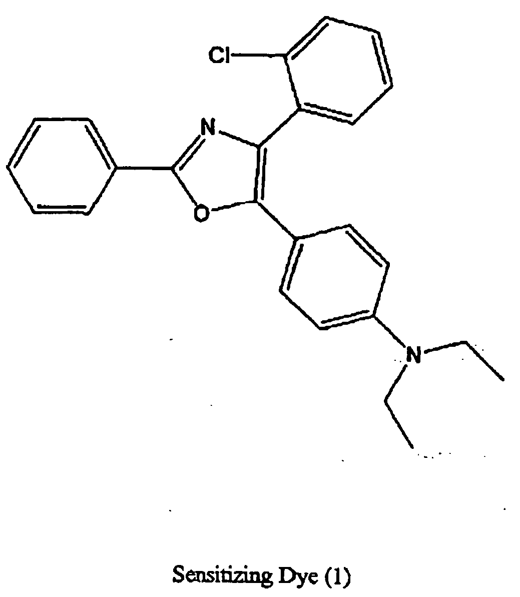

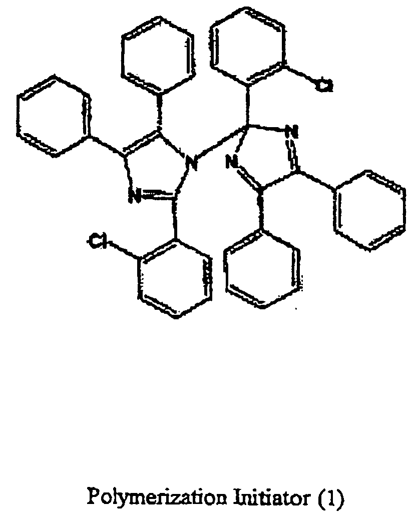

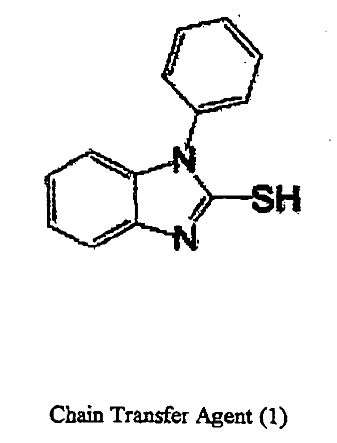

### (3) Formation of Protective Layer

A coating solution for protective layer (1) having the composition shown below was coated on the photosensitive layer so as to have a dry coating amount of 2.3 g/m² and dried at 125°C for 75 seconds to form a protective layer, whereby Lithographic printing plate precursor 1 was prepared.

### Coating Solution for Protective Layer

| | | |
|---|---|---|
| | Polyvinyl alcohol (sapom6cation degree: 95% by mole, polymerization degree: 500) | 36 parts by weight |
| | Polyvinyl pyrrolidone (molecular weight: 50,000) | 9 parts by weight |
| | Copolymer of vinyl pyrrolidone and vinyl acetate (1/1) (molecular weight: 70,000) | 0.5 parts by weight |
| | Surfactant (Emalex 710, produced by Nihon Emulsion Co., Ltd.) | 0.5 parts by weight |
| | Water | 950 parts by weight |

### COMPARATIVE EXAMPLE 1

Lithographic printing plate precursor 1' for comparison was prepared in the same manner as in Example 1 except for changing Binder polymer (1) in Photopolymerizable composition P-1 of Example 1 to Binder polymer (2) shown below.

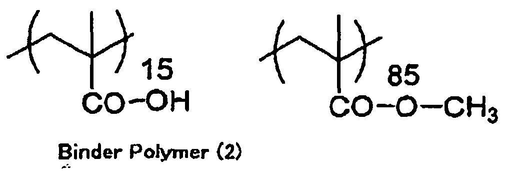

### EXAMPLE 2

Lithographic printing plate precursor 2 was prepared in the same manner as in Example 1 except for changing Binder polymer (1) in Photopolymerizable composition F-1 of Example 1 to Binder polymer (3) shown below.

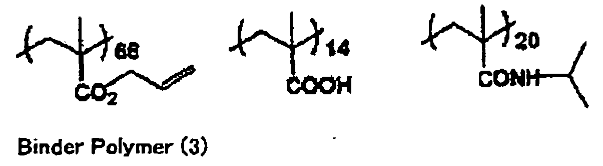

### EXAMPLE 3

Lithographic printing plate precursor 3 was prepared in the same manner as in Example 1 except for changing Binder polymer (1) in Photopolymerizable composition P-1 of Example 1 to Binder polymer (4) shown below.

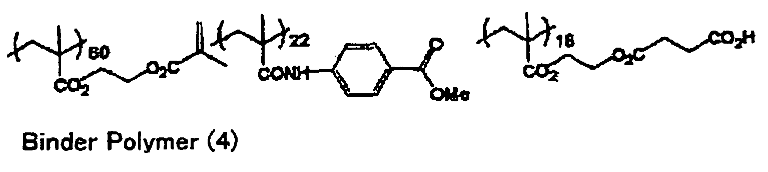

### EXAMPLES 4 TO 8

Lithographic printing plate precursors 4 to 8 were prepared in the same manner as in Example 1 except for changing Chain transfer agent (1) in Photopolymerizable composition P-1 of Example 1 to Chain transfer agents (2) to (6) shown below, respectively.

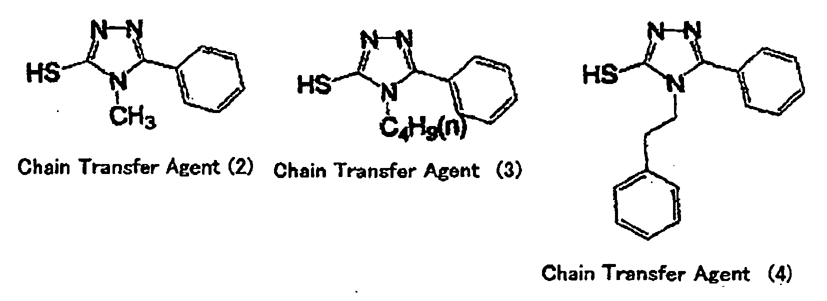

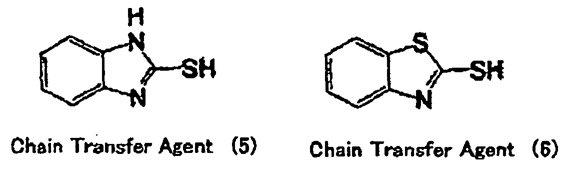

### EXAMPLE 9

Lithographic printing plate precursor 9 was prepared in the same manner as in Example 1 except for changing Polymerization initiator (1) in Photopolymerizable composition P-1 of Example 1 to Polymerization initiator (2) shown below and adding 0.3 parts by weight of Polymerization initiator (3) shown below as a sensitizing aid.

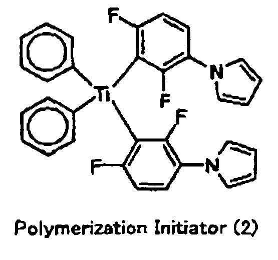

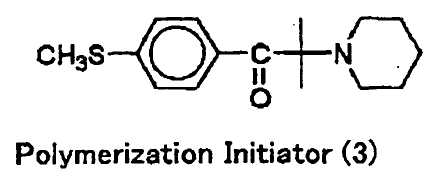

### EXAMPLE 10

Lithographic printing plate precursor 10 was prepared in the same manner as in Example 1 except for using a support prepared in the following manner.

### (1) Preparation of support

A 0.3 mm-thick aluminum plate (JIS 1050 material) was subjected to a degreasing treatment at 50°C for 30 seconds using a 10% by weight aqueous sodium aluminate solution for removing rolling oil on the surface thereof and then grained the surface using three nylon brushes embedded with bundles of nylon bristle having a diameter of 0.3 mm and an aqueous suspension (specific gravity: 1.1 g/cm³ of pumice having a median size of 25 µm), followed by thorough washing with water. The aluminum plate was etched by immersing in a 25% by weight aqueous sodium hydroxide solution of 45°C for 9 seconds, washed with water, then immersed in a 20% by weight aqueous nitric acid solution of 60°C for 20 seconds, and washed with water. The etching amount of the grained surface of the aluminum plate was about 3 g/m².

Then, using an alternating current of 60 Hz, an electrochemical roughening treatment was continuously carried out on the surface of the aluminum plate. The electrolyte used was a 1% by weight aqueous nitric acid solution (containing 0.5% by weight of aluminum ion) and the electrolyte temperature was 50°C. The electrochemical roughening treatment was conducted using an alternating current source, which provides a trapezoidal rectangular wave alternating current of 0.8 msec in time TP for the current to reach its peak from zero and 1:1 in duty ratio, and using a carbon electrode as a counter electrode. A ferrite was used as an auxiliary anode. The current density was 30 A/dm² in the peak value of the electric current. To the auxiliary anode, 5% of the electric current from the electric source was distributed. The quantity of electricity in the nitric acid electrolysis was 175 Coulomb/dm² in terms of the quantity of electricity during the aluminum plate functioning as an anode. The aluminum plate was then washed with water by spraying.

The aluminum plate was further subjected to electrochemical roughening treatment in the same manner as in the nitric acid electrolysis using as an electrolyte, a 0.5% by weight aqueous hydrochloric acid solution (containing 0.5% by weight of aluminum ion) having temperature of 50°C and under the condition that the quantity of electricity was 50 Coulomb/dm² in terms of the quantity of electricity during the aluminum plate functioning as an anode. The aluminum plate was then washed with water by spraying. The aluminum plate was subjected to an anodizing treatment using as an electrolyte, a 15% by weight aqueous sulfuric acid solution (containing 0.5% by weight of aluminum ion) at a current density of 15 A/dm² to form a direct current anodic oxide film of 2.5 g/m², washed with water, dried, and then treated with a 2.5% by weight aqueous sodium silicate solution at 30°C for 10 seconds. The center line average roughness (Ra) of the aluminum plate was measured using a stylus having a diameter of 2 µm and as a result, it was found to be 0.51 µm.

To the aluminum plate thus-treated was applied the intermediate layer same as in Example 1.

### 2: Evaluation of Lithographic Printing Plate Precursor

### (1) Printing Durability

The lithographic printing plate precursor obtained was subjected to imagewise drawing using Vx9600CTP (wavelength of light source: 405 nm, produced by Fuji Photo Film Co., Ltd.) while controlling an exposure amount on the surface of the lithographic printing plate precursor to 0.05 mJ/cm². Then, the lithographic printing plate precursor was preheated at temperature of 115°C for 12 seconds and developed using a PS processor (IP850HD, produced by G & J) fed with an alkali developer having the composition shown below at the solution temperature of 25°C for development time of 28 seconds. As a finisher, an aqueous solution prepared by diluting FN-6 (produced by Fuji Photo Film Co., Ltd.) with 3 times of water was used.

The lithographic printing plate obtained was subjected to printing by a printing machine (Lithrone, produced by Komori Corp.) using ink (DIC-GEOS (N) Black, produced by Dainippon Ink & Chemicals, Inc.) and a mixture of etching solution (EU-3, produced by Fuji Photo Film Co., Ltd.)/water/isopropyl alcohol = 1/89/10 (in a volume ratio), and a number of sheets when it was visually recognized that the density of solid image area began to become thin was determined to evaluate the printing durability.

### Composition of Alkali Developer

| | | |
|---|---|---|
| | Potassium hydroxide | 0.15 g |
| | Polyoxyethylene naphthyl ether (n=13) | 5.0 g |
| | Chelest 400 (chelating agent) | 0.1 g |
| | Water | 94.75 g |

### (2) Reproducibility of Fine Lines

The printing was performed as described above and after the confirmation that a print free from ink stain in the non-image area was obtained after conducting the printing of 100 sheets, further printing of 4,900 sheets was continuously carried out On the 5,000th sheet in total, a fine line chart (a chart including fine lines having 10, 12, 14, 16, 18, 20, 25, 30, 35, 40, 60, 80, 100 and 200 µm in width, respectively) printed was observed by a 25-power magnifier and the width of fine line reproduced by ink on the sheet without interruption was determined to evaluate the reproducibility of fine lines.

The results of the evaluations are shown in Table 1 blow.

**TABLE 1**

| | Lithographic Printing Plate | Printing Durability (x 10⁴ sheets) | Reproducibility of Fine Lines (µm) |
|---|---|---|---|
| Example 1 | 1 | 20 | 18 |
| Example 2 | 2 | 15 | 20 |
| Example3 3 | 3 | 17 | 20 |
| Example 4 | 4 | 20 | 18 |
| Example 5 | 5 | 19 | 18 |
| Example 6 | 6 | 18 | 20 |
| Example 7 | 7 | 15 | 25 |
| Example 8 | 8 | 15 | 25 |
| Example 9 | 9 | 20 | 18 |
| Example 10 | 10 | 20 | 18 |
| Comparative Example 1 | 1' | 10 | 35 |

From the results shown in Table 1 above, it can be seen that the lithographic printing plate of the invention are excellent in the printing durability and reproducibility of fine lines.

This application is based on Japanese Patent application JP 2005-59193, filed March 3, 2005.

## Claims

1. A lithographic printing plate precursor comprising a support and a photosensitive layer containing:
(A) a sensitizing dye represented by the following formula (I), 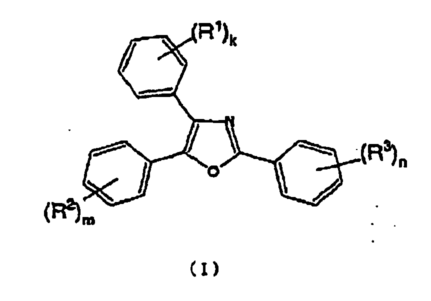 wherein R¹, R² and R³ each independently represents a halogen atom, an alkyl group which may have a substituent, an aryl group which may have a substituent, an aralkyl group which may have a substituent, an -NR⁴R⁵ group or an - OR⁶ group; R⁴, R⁵ and R⁶ each independently represents a hydrogen atom, an alkyl group which may have a substituent, an aryl group which may have a substituent or an aralkyl group which may have a substituent; and k, m and n each independently represents 0 or an integer of 1 to 5;
(B) a polymerization initiator,
(C) a polymerizable compound, and
(D) a binder polymer having a molecular weight of 10,000 to 200,000 and having a crosslinkable group.

2. A lithographic printing plate precursor according to Claim 1, wherein k, m and n in the formula (I) each independently represents 0 or 1.

3. A lithographic printing plate precursor according to Claim 1 or Claim 2, wherein at least one of R¹, R² and R³ in the formula (I) represents a -NR⁴R⁵ group.

4. The lithographic printing plate precursor according to Claim 1, wherein the binder polymer (D) is a (meth)acrylic copolymer having a crosslinkable group in a side chain or a polyurethane resin having a crosslinkable group in a side chain.

5. A lithographic printing plate precursor according to any preceding claim, wherein the photosensitive layer further contains (E) a chain transfer agent.

6. The lithographic printing plate precursor according to Claim 5, wherein the chain transfer agent (E) is a thiol compound represented by the following formula (II), 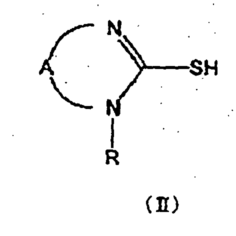 wherein R represents an alkyl group which may have a substituent or an aryl group which may have a substituent; and A represents an atomic group necessary for forming a 5-membered or 6-membered hetero ring containing a carbon atom together with the N=C-N linkage, and A may have a substituent.

7. A lithographic printing plate precursor according to any preceding claim, wherein the polymerization initiator (B) is a hexaarylbiimidazole compound or a metallocene compound.

8. A lithographic printing plate precursor according to any preceding claim, which further comprises a protective layer so that the support, the photosensitive layer and the protective layer are provided in this order.

9. A method for making a lithographic printing plate comprising:
imagewise exposing a lithographic printing plate precursor as defined in any preceding claim with a laser beam having a wavelength of from 350 to 600 nm, and
processing the exposed lithographic printing plate precursor with a developer.

10. A plate-making method according to Claim 9, wherein the developer contains a non-ionic surfactant having a polyoxyalkylene ether group.

11. A plate-making method according to Claim 10, wherein the non-ionic surfactant having a polyoxyalkylene ether group has the following formula (VI):
R₄₀-O-(R₄₁-O)ₚH (VI)
wherein R₄₀ represents an optionally substituted C₃₋₁₅ alkyl group, an optionally substituted C₆₋₁₅ aromatic hydrocarbon group or an optionally substituted C₄₋₁₅ heteroaromatic ring group;
R₄₁ represents an optionally substituted C₁₋₁₀₀ alkylene group; and
p represents an integer of 1-100.

12. A plate-making method according to any of Claims 9-11, wherein the developer has a pH of 11.0-12.7.

## Patentansprüche

1. Lithographischer Druckplattenvorläufer, umfassend einen Träger und eine lichtempfindliche Schicht, umfassend
(A) einen sensibilisierenden Farbstoff, dargestellt durch die folgende Formel (I): 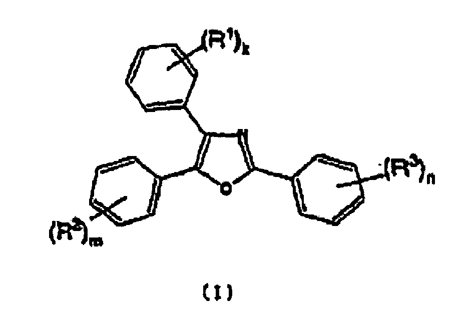 worin R¹, R² und R³ jeweils unabhängig ein Halogenatom, eine Alkylgruppe, die einen Substituenten haben kann, Arylgruppe, die einen Substituenten haben kann, Aralkylgruppe, die einen Substituenten haben kann, - NR⁴R⁵-Gruppe oder -OR⁶-Gruppe sind, R⁴, R⁵ und R⁶ jeweils unabhängig ein Wasserstoffatom, eine Alkygruppe, die einen Substituenten haben kann, eine Arylgruppe, die einen Substituenten haben kann oder Aralkylgruppe sind, die einen Substituenten haben kann, und k, m und n jeweils unabhängig 0 oder eine ganze Zahl von 1 bis 5 sind,
(B) einen Polymerisationsinitiator,
(C) eine polymerisierbare Verbindung und
(D) ein Bindemittelpolymer mit einem Molekulargewicht von 10.000 bis 200.000 und mit einer vernetzbaren Gruppe.

2. Lithographischer Druckplattenvorläufer nach Anspruch 1, worin k, m und n in der Formel (I) jeweils unabhängig 0 oder 1 sind.

3. Lithographischer Druckplattenvorläufer nach Anspruch 1 oder 2, worin zumindest eines von R¹, R² und R³ in der Formel (I) eine -NR⁴R⁵-Gruppe ist.

4. Lithographischer Druckplattenvorläufer nach Anspruch 1, worin das Bindemittelpolymer (D) ein (Meth)acrylCopolymer mit einer vernetzbaren Gruppe in einer Seitenkette oder ein Polyurethanharz mit einer vernetzbaren Gruppe in einer Seitenkette ist.

5. Lithographischer Druckplattenvorläufer nach einem der vorhergehenden Ansprüche, worin die lichtempfindliche Schicht weiterhin (E) ein Kettenübertragungsmittel umfasst.

6. Lithographischer Druckplattenvorläufer nach Anspruch 5, worin das Kettenübertragungsmittel (E) eine Thiolverbindung mit der folgenden Formel (II) ist: 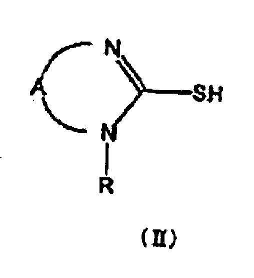 worin R eine Alkylgruppe, die einen Substituenten haben kann, oder eine Arylgruppe ist, die einen Substituenten haben kann; und A eine Atomgruppe ist, die zur Bildung eines 5- oder 6-gliedrigen Heteroringes mit einer Kohlenstoffzahl zusammen mit der N=C-N-Bindung notwendig ist, und A einen Substituenten haben kann.

7. Lithographischer Druckplattenvorläufer nach einem der vorhergehenden Ansprüche, worin der Polymerisationsinitiator (B) eine Hexaarylbiimidazolverbindung oder Metallozenverbindung ist.

8. Lithographischer Druckplattenvorläufer nach einem der vorhergehenden Ansprüche, die weiterhin eine Schutzschicht umfasst, sodass der Träger, die lichtempfindliche Schicht und die Schutzschicht in dieser Reihenfolge vorgesehen sind.

9. Verfahren zur Erzeugung einer lithographischen Druckplatte, umfassend das bildweise Belichten eines lithographischen Druckplattenvorläufers wie in einem der vorhergehenden Ansprüche definiert mit einem Laserstrahl mit einer Wellenlänge von 350 bis 600 nm und das Verarbeiten des belichteten lithographischen Druckplattenvorläufers mit einem Entwickler.

10. Plattenerzeugungsverfahren nach Anspruch 9, worin der Entwickler ein nichtionisches Tensid mit einer Polyoxyalkylenethergruppe umfasst.

11. Plattenerzeugungsverfahren nach Anspruch 10, worin das nichtionische Tensid mit einer Polyoxyalkylenethergruppe die folgende Formel (VI) hat:
R₄₀-O-(R₄₁-O)ₚH (VI)
worin R₄₀ eine wahlweise substituierte C₃₋₁₅-Alkylgruppe, wahlweise substituierte C₆₋₁₅ aromatische Kohlenwasserstoffgruppe oder wahlweise substituierte C₄₋₁₅ heteroaromatische Ringgruppe ist;
R₄₁ eine wahlweise substituierte C₁₋₁₀₀-Alkylengruppe ist und p eine ganze Zahl von 1 bis 100 ist.

12. Plattenerzeugungsverfahren nach einem der Ansprüche 9 bis 11, worin der Entwickler einen pH von 11,0 bis 12,7 hat.

## Revendications

1. Précurseur de plaque d'impression lithographique, comprenant un support et une couche photosensible contenant :
(A) un colorant sensibilisant représenté par la formule (I) suivante : 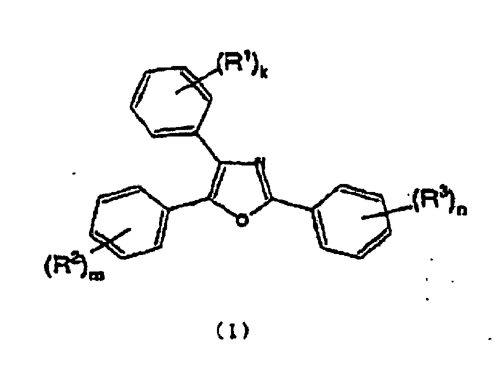 où R¹, R² et R³ représentent chacun indépendamment, un atome d'halogène, un radical alkyle qui peut avoir un substituant, un radical aryle qui peut avoir un substituant, un radical aralkyle qui peut avoir un substituant, un radical -NR⁴R⁵ ou un radical -OR⁶ ; R⁴, R⁵ et R⁶ représentent chacun indépendamment, un atome d'hydrogène, un radical alkyle qui peut avoir un substituant, un radical aryle qui peut avoir un substituant, un radical aralkyle qui peut avoir un substituant ; et k, m et n représentent chacun indépendamment, 0 ou un entier allant de 1 à 5 ;
(B) un initiateur de polymérisation ;
(C) un composé polymérisable, et
(D) un polymère liant ayant un poids moléculaire allant de 10 000 à 200 000 et ayant un radical réticulable.

2. Précurseur de plaque d'impression lithographique selon la revendication 1, où k, m et n dans la formule (I) représentent chacun indépendamment, 0 ou 1.

3. Précurseur de plaque d'impression lithographique selon la revendication 1 ou 2, où au moins un de R¹, R² et R³ dans la formule (I), représente un radical -NR⁴R⁵.

4. Précurseur de plaque d'impression lithographique selon la revendication 1, où le polymère liant (D) est un copolymère (méth)acrylique ayant un radical réticulable dans une chaîne latérale ou une résine polyuréthanne ayant un radical réticulable dans une chaîne latérale.

5. Précurseur de plaque d'impression lithographique selon l'une quelconque des revendications précédentes, où la couche photosensible contient en outre, (E) un agent de transfert de chaîne.

6. Précurseur de plaque d'impression lithographique selon la revendication 5, où l'agent de transfert de chaîne (E) est un composé thiol représenté par la formule (II) suivante : 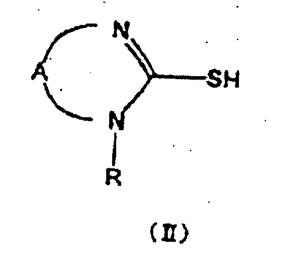 où R représente un radical alkyle qui peut avoir un substituant ou un radical aryle qui peut avoir un substituant, et A représente un groupe atomique nécessaire pour former un hétérocycle à 5 ou 6 membres, contenant un atome de carbone avec la liaison N=C-N, et A peut porter un substituant.

7. Précurseur de plaque d'impression lithographique selon l'une quelconque des revendications précédentes, où l'initiateur de polymérisation (B) est un composé hexaarylbiimidazole ou un composé métallocène.

8. Précurseur de plaque d'impression lithographique selon l'une quelconque des revendications précédentes, qui comprend en outre, une couche protectrice de sorte que le support, la couche photosensible et la couche protectrice sont disposés en cet ordre.

9. Procédé de préparation d'une plaque d'impression lithographique, comprenant :
l'exposition sous forme d'une image, d'un précurseur de plaque d'impression lithographique tel que défini dans l'une quelconque des revendications précédentes, avec un faisceau laser ayant une longueur d'onde allant de 350 à 600 nm, et
le traitement du précurseur de plaque d'impression lithographique exposé avec un agent de développement.

10. Procédé de préparation de plaque selon la revendication 9, dans lequel l'agent de développement contient un tensioactif non ionique ayant un radical éther polyoxyalkylène.

11. Procédé de préparation de plaque selon la revendication 10, dans lequel le tensioactif non ionique ayant un radical éther polyoxyalkylène a la formule (IV) suivante :
R₄₀-O-(R₄₁-O)ₚH (IV)
Où R₄₀ représente un radical alkyle en C₃₋₁₅ le cas échéant substitué, un radical hydrocarbure aromatique en C₆₋₁₅ le cas échéant substitué ou un radical cyclique hétéroaromatique en C₄₋₁₅ le cas échéant substitué ;
R₄₁ représente un radical alkylène en C₁₋₁₀₀ le cas échéant substitué, et
p représente un entier allant de 1 à 100.

12. Procédé de préparation de plaque selon l'une quelconque des revendications 9-11, dans lequel l'agent de développement a un pH allant de 11,0 à 12,7.
